# EUROPEAN PATENT APPLICATION

(11) **EP 4 286 439 A1**
(43) Date of publication of application: **06.12.2023**
(21) Application number: 22745975.7
(22) Date of filing: 27.01.2022
(51) Int. Cl.: C08G 18/42, H01L 21/304

(54) **HOLLOW MICROBALLOON**

(30) Priority: 29.01.2021 JP 2021012696
(71) Applicant: Tokuyama Corporation, Shunan-shi, Yamaguchi 745-8648 (JP)
(72) Inventor: SHIMIZU, Yasutomo, Shunan-shi, Yamaguchi 745-8648 (JP); FUKUDA, Kazuishi, Shunan-shi, Yamaguchi 745-8648 (JP); KAWASAKI, Takayoshi, Shunan-shi, Yamaguchi 745-8648 (JP)
(74) Representative: Gerauer, Marc Philippé
(86) International application number: PCT/JP2022/003093
(87) International publication number: WO 2022/163756

(57) **Abstract**

The hollow microballoon of the invention includes a resin produced by polymerizing a polymerizing composition that contains a cyclic molecule having at least three side chains with a polymerizable functional group introduced into the terminal thereof and a polymerizable monomer other than the cyclic molecule having at least three side chains with a polymerizable functional group introduced into the terminal thereof. According to the invention, there are provided hollow microballoon capable of imparting not only polishing characteristics but also excellent durability to a CMP polishing pad using the hollow microballoon.

## Description

### Technical Field

The present invention relates to hollow microballoon.

### Background Art

Heretofore, microballoons have been used in various fields including agriculture, medicines, fragrances, liquid crystals, adhesives, electronic material parts and building materials, as microballoons encapsulating a skincare component, a fragrance component, a dye component, an analgesic component, a deodorant component, an antioxidant component, a bactericidal component, a heat storage component or the like, or as hollow microballoon that are hollow inside the microballoons.

Recently, in particular, hollow microballoon have been investigated for the purpose of forming fine pores in polyurethane(urea)-made polishing pads for CMP (chemical mechanical polishing) for use for wafer polishing.

Heretofore, as hollow microballoon for use for CMP polishing pads, there have been known vinylidene chloride resin microballoons formed by dusting the surfaces of hollow microballoon with inorganic particles, and the like for the purpose of improving dispersibility in polyurethane(urea), in which, however, there is a possibility that the inorganic particles may cause wafer defects.

Therefore, the present inventors have proposed a polishing pad for CMP having excellent polishing characteristics, by using hollow microballoon formed of a polyurethane(urea) resin film having high elasticity and having good compatibility with a polyurethane(urea) resin, in a CMP polishing pad (see PTL 1).

However, with recent micronization of semiconductor interconnections, polishing pads for CMP with higher performance have been demanded, and further improvements in durability and resin physical properties of hollow microballoon have been demanded.

On the other hand, also for other uses than use for CMP polishing pads, improvements in resin physical properties, such as durability of microballoons have been demanded, and PTL 2 discloses, regarding polyurethane(urea) microballoons that encapsulate a heat storage material, a technique of incorporating a polyrotaxane in polyurethane(urea) to improve durability to thereby prevent leakage of the heat storage material.

### Citation List

### Patent Literature

PTL 1: WO2019/198675A1
PTL 2: WO2013/176050A1

### Summary of Invention

### Technical Problem

However, as a result of investigation by the present inventors, it has been known that the method described in PTL 2 can be effective for microballoons that encapsulate a heat storage material, but cannot attain satisfactory durability when applied to hollow microballoon. In addition, polyrotaxane tends to have a high molecular due to its specific structure, and has room for improvement in that the handleability thereof is poor, in using it as hollow microballoon, its production is limited, and the like.

Accordingly, an object of the present invention is to provide hollow microballoon having good handleability and capable of providing not only polishing characteristics but also excellent durability.

### Solution to Problem

The present inventors have assiduously studied for the purpose of solving the above-mentioned problems and, as a result, have found that, by using a hollow microballoon including a resin produced by polymerizing a polymerizing composition that contains a cyclic molecule having at least three side chains with a polymerizable functional group introduced into the terminal thereof and a polymerizable monomer other than the cyclic molecule having at least three side chains with a polymerizable functional group introduced into the terminal thereof, the above-mentioned problems can be solved, and have completed the present invention.

Specifically, the present invention provides a hollow microballoon including a resin produced by polymerizing a polymerizing composition that contains a cyclic molecule having at least three side chains with a polymerizable functional group introduced into the terminal thereof and a polymerizable monomer other than the cyclic molecule having at least three side chains with a polymerizable functional group introduced into the terminal thereof.

Also the present invention provides a polishing pad for CMP that includes the hollow microballoon.

The present invention relates to the following [1] to [7].
[1] A hollow microballoon comprising a resin produced by polymerizing a polymerizing composition that contains (A) a cyclic molecule having at least three side chains with a polymerizable functional group introduced into the terminal thereof and (B) a polymerizable monomer other than the (A) cyclic molecule having at least three side chains with a polymerizable functional group introduced into the terminal thereof.
[2] The hollow microballoon according to the above [1], wherein the content of the (A) cyclic molecule having at least three side chains with a polymerizable functional group introduced into the terminal thereof in the polymerizable composition is 1 to 50 parts by mass relative to 100 parts by mass of the total of the content of the (A) cyclic molecule having at least three side chains with a polymerizable functional group introduced into the terminal thereof and the content of the (B) polymerizable monomer other than the (A) cyclic molecule having at least three side chains with a polymerizable functional group introduced into the terminal thereof.
[3] The hollow microballoon according to the above [1] or [2], wherein the resin comprises a urethane(urea) resin, a melamine resin, a urea resin or an amide resin.
[4] The hollow microballoon according to any one of the above [1] to [3], wherein the polymerizable functional group of the (A) cyclic molecule having at least three side chains with a polymerizable functional group introduced into the terminal thereof comprises a hydroxy group or an amino group.
[5] The hollow microballoon according to any one of the above [1] to [4], wherein the cyclic molecule comprises a cyclodextrin.
[6] The hollow microballoon according to any one of the above [1] to [5], wherein the viscosity at 60°C of the (A) cyclic molecule having at least three side chains with a polymerizable functional group introduced into the terminal thereof is 500 mPa·s to 50,000 mPa·s
[7] A polishing pad for CMP including the hollow microballoon of any one of the above [1] to [6].

### Advantageous Effects of Invention

The hollow microballoon of the present invention includes a resin produced by polymerizing a polymerizing composition that contains a cyclic molecule having at least three side chains with a polymerizable functional group introduced into the terminal thereof. With that, in producing the hollow microballoon, the handleability thereof is good, and the hollow microballoon can be given excellent durability.

A polishing pad for CMP that includes such hollow microballoon can express excellent polishing characteristics. For example, it is possible to realize a high polishing rate and to reduce wafer defects.

The present inventors have found that, by using a cyclic molecule having at least three side chains with a polymerizable functional group introduced into the terminal thereof as one constituent component of a resin, the resin can be given excellent mechanical characteristics such as high durability and excellent elastic recovery performance against deformation.

With that, the inventors have found that, not using a cyclic molecule having at least three side chains with a polymerizable functional group introduced into the terminal thereof as one constituent component of a resin containing hollow microballoon but using it as one constituent component to constitute hollow microballoon, the hollow microballoon is given the above-mentioned stress dispersion performance and elastic recovery performance and the hollow microballoon can have excellent durability. By applying such hollow microballoon to a polishing pad for CMP, it becomes possible to express not only a role of forming fine pores on the polishing surface of a polishing pad for CMP owing to the above-mentioned stress dispersion performance and elastic recovery performance that the hollow microballoon has but also to provide a polishing pad for CMP having durability and capable of expressing excellent polishing characteristics and also excellent wear resistance. Further, owing to the characteristics, it becomes possible to reduce wafer defects to occur owing to the polishing sludge of hollow microballoon to be discharged in polishing.

Further, in addition to the use for CMP polishing pads, the hollow microballoon of the present invention is also usable in other various fields of thermal recording materials, agricultural chemicals, medicines, fragrances, liquid crystals, adhesives, electronic material parts, building materials, etc.

### Description of Embodiments

The hollow microballoon of the present invention is hollow microballoon includes a resin produced by polymerizing a polymerizing composition that contains (A) a cyclic molecule having at least three side chains with a polymerizable functional group introduced into the terminal thereof (hereinafter this may be referred to also as "cyclic polyfunctional monomer (A)", or "component (A)"), and (B) a polymerizable monomer other than the cyclic polyfunctional monomer (A) (hereinafter this may be referred to also as "polymerizable monomer (B)", or "component (B)").

The hollow microballoon is a particle having a cavity therein, and is composed of a hollow portion and an outer shell portion. The resin formed by polymerizing the above-mentioned polymerizable composition forms the outer shell portion of a hollow microballoon.

First, the cyclic polyfunctional monomer (A) is described.

### <(A) Cyclic Polyfunctional Monomer>

First described is the cyclic molecule used in the cyclic polyfunctional monomer (A). The cyclic molecule is not specifically limited so far as it is a cyclic molecule into which a side chain with a polymerizable functional group introduced into the terminal thereof can be introduced. Examples of the cyclic molecule include cyclodextrin, crown ether, benzocrown, dibenzocrown, dicyclohexanocrown, cyclobis(paraquat- 1,4-phenylene), dimethoxypillararene, calixresorcinarene, calixarene, and phenanthroline. Above all, cyclodextrin and calixresorcinarene are preferred, and cyclodextrin is most preferred.

The cyclodextrin includes an α-form (ring inner diameter 0.45 to 0.6 nm), a β- form (ring inner diameter 0.6 to 0.8 nm) and a γ-ring (ring inner diameter 0.8 to 0.95 nm). A mixture of these can also be used in the present invention. Above all, in the present invention, an α-cyclodextrin and a β-cyclodextrin are preferred, and a β-cyclodextrin is most preferred from the viewpoint of cost and physical properties.

Calixresorcinarene is a cyclic molecule produced by cyclocondensation of a resorcinol and various aldehydes. The resorcinol is not limited to resorcinol alone, but includes resorcinol derivatives such as 2-nitroresorcinol. As the aldehyde, any known aldehyde can be used with no specific limitation, and examples thereof include aliphatic aldehydes such as n-butanal, isobutanal and heptanal; and aromatic aldehydes such as benzaldehyde, vanillin and 4-nitrobenzaldehyde. Two or more of these can be mixed and used. Above all, heptanal, benzaldehyde and vanillin are preferably used. In the present invention, the calixresorcinarene is preferably a tetramer, but is not limited thereto.

Next described is the side chain with a polymerizable functional group introduced into the terminal thereof that the cyclic molecule has. The cyclic molecule for use in the cyclic polyfunctional monomer (A) in the present invention has at least three side chains with a polymerizable functional group introduced into the terminal thereof.

The polymerizable functional group introduced into the terminal of the side chain is not specifically limited so far as it is a group capable of polymerizing with the polymerizable monomer (B) to be mentioned later, but is preferably a hydroxy group or an amino group.

The side chain with a polymerizable functional group introduced into the terminal thereof can be introduced by modifying the reactive functional group that the cyclic molecule has, for example, by utilizing the reactive functional group of the cyclic molecule. (Namely, the side chain is introduced by reaction with the reactive functional group.)

Examples of the reactive functional group include a hydroxy group and an amino group, and above all, a hydroxy group is preferred. For example, a β-cyclodextrin has 21 OH groups (hydroxy groups) as reactive functional groups, and the side chain is introduced by reaction with the OH group. Accordingly, at most 21 side chains can be introduced into one β-cyclodextrin. In the present invention, for sufficiently exhibiting the function of the side chain mentioned above, at least three side chains with a polymerizable functional group introduced into the terminal thereof need to be introduced. Preferred is a cyclic molecule having at least 5 side chains with a polymerizable functional group introduced into the terminal thereof, more preferred is a cyclic molecule having at least 7 side chains with a polymerizable functional group introduced into the terminal thereof, and even more preferred is a cyclic molecule having at least 8 side chains with a polymerizable functional group introduced into the terminal thereof. The upper limit is not specifically limited, but when the number of the introduced side chains is too large, the viscosity of the cyclic polyfunctional monomer may increase and the handleability thereof may worsen. Consequently, it is especially preferable that 8 to 18 such side chains are introduced.

Not specifically limited, the side chain is preferably formed of repetition of an organic chain having 3 to 20 carbon atoms. The number-average molecular weight of the side chain of the type is, for example, preferably 300 or more. In more detail, the number-average molecular weight of the side chain can fall within a range of 300 to 10000, preferably 350 to 5000, most preferably 400 to 5000, and most preferably 400 to 1500. Falling within the range, the hardness and the physical properties of the resultant hollow microballoon and a CMP polishing pad containing the hollow microballoon can be readily controlled. The number-average molecular weight of the side chain can be controlled by controlling the amount to be used in introducing the side chain, and can be determined by calculation, and also by ¹H-NMR measurement.

By limiting the lower limit of the number-average molecular weight of the side chain as mentioned above, excellent mechanical characteristics can be expressed, and when the component (A) is used as one constituent component to constitute the hollow microballoon of the present invention, the hollow microballoon can express excellent wear resistance and mechanical characteristics, and when applied to a CMP polishing pad, excellent polishing rate and scratch resistance performance to wafers can improve. Further, the compatibility with the polymerizable monomer (B) tends to improve. On the other hand, by controlling the upper limit of the number-average molecular weight of the side chain as mentioned above, wear resistance tends to not lower.

The cyclic polyfunctional monomer (A) preferably has a certain viscosity range. With that, excellent handleability can be attained. A preferred viscosity range at 60°C is 500 mPa .s to 50,000 mPa ·s, more preferred is 500 mPa .s to 10,000 mPa ·s, most preferred is 1000 mPa .s to 6,000 mPa ·s. These can be measured, for example, with a rotary viscometer.

Further, when the molecular weight of the cyclic polyfunctional monomer (A) is too large, not only it becomes difficult to handle in mixing with other component such as the polymerizable monomer (B) but also the miscibility thereof tends to worsen. From this viewpoint, the weight-average molecular weight Mw of the cyclic polyfunctional monomer (A) is preferably within a range of 1,500 to 100,000, more preferably 2,000 to 30,000, even more preferably 2,500 to 10,000, most preferably 3,000 to 8,000. For the purpose of exhibiting stable physical properties, the dispersion degree (weight-average molecular weight/number-average molecular weight) is preferably 1.2 or less. The weight-average molecular weight Mw and the dispersion degree are values measured according to the GPC measurement method described in the section of Examples given below. Also as mentioned above, when the molecular weight of the cyclic polyfunctional monomer (A) is too large, the handleability and the miscibility tend to worsen, and therefore it is preferable that the cyclic polyfunctional monomer (A) does not form a complex with any other molecule.

In the present invention, the side chain may be linear or branched. For introduction of the side chain, a known method may be appropriately employed, and for example, methods and compounds disclosed in WO2015/159875A can be appropriately used. Specifically, ring-cleavage polymerization; radical polymerization; cationic polymerization; anionic polymerization; and living radical polymerization such as atom transfer radical polymerization, RAFT polymerization or NMP polymerization can be utilized. According to the method, a suitably selected compound may be reacted with the reactive functional group that the cyclic molecule has to introduce a side chain of an appropriate size.

For example, by ring-cleavage polymerization, a side chain derived from a cyclic compound such as a cyclic ether, a cyclic siloxane, a cyclic lactone, a cyclic lactam, a cyclic acetal, a cyclic amine, a cyclic carbonate, a cyclic iminoether or a cyclic thiocarbonate can be introduced.

Among the cyclic compounds, from the viewpoint of high reactivity and easiness in molecular weight control, a cyclic ether, a cyclic lactone and a cyclic lactam are preferably used.

For side chains introduced by ring-cleavage polymerization of a cyclic compound such as a cyclic lactone or a cyclic ether, a hydroxy group is introduced into the terminal of the side chain; and for side chains introduced by ring-cleavage polymerization of a cyclic lactam, an amino group is introduced into the terminal of the side chain.

Hereinunder cyclic ethers, cyclic lactones, cyclic lactams and cyclic carbonates preferably used here are exemplified.

### Cyclic Ether;

Ethylene oxide, 1,2-propylene oxide, epichlorohydrin, epibromohydrin, 1,2-butylene oxide, 2,3-butylene oxide, isobutylene oxide, oxetane, 3-methyloxetane, 3,3-dimehtyloexetane, tetrahydrofuran, 2-methyltetrahydrofuran, 3-methyltetrahydrofuran.

### Cyclic lactone;

4-Membered lactone; β-propiolactone, β-methylpropiolactone, L-serine-β-lactone.

5-Membered lactone; γ-butyrolactone, γ-hexanolactone, γ-heptanolactone, γ-octanolactone, γ-decanolactone, γ-dodecanolactone, , α-hexyl-γ-butyrolactone, α-heptyl-γ-butyrolactone, α-hydroxy-γ-butyrolactone, γ-methyl-γ-decanolactone, α-methylene-γ-butyrolactone, α,α-dimethyl-γ-butyrolactone, D-erythrolactone, α-methyl-γ-butyrolactone, γ-nonanolactone, DL-pantolactone, γ-phenyl-γ-butyrolactone, γ-undecanolactone, γ-valerolactone, 2,2-pentamethylene-1,3-dioxolan-4-one, α-buromo-γ-butyrolactone, γ-chrotonolactone, α-methylene-γ butyrolactone, α-methacryloyloxy-γ-butyrolactone, β-methacryloyloxy-γ-butyrolactone.

6-Membered lactone; δ-valerolactone, δ-hexanolactone, δ-octanolactone, δ-nonalactone, δ-decanolactone, δ-undecanolactone, δ-dodecanolactone, δ-tridecanolactone, δ-tetradecanolactone, DL-mevalonolactone, δ-lactone 4-hydroxy-1-cyclohexanecarboxylate, monomethyl-δ-valerolactone, monoethyl-δ-valerolactone, monohexyl-δ-valerolactone, 1,4-dioxan-2-one, 1,5-dioxepan-2-one.

7-Membered lactone; ε-caprolactone, monomethyl-ε-caprolactone, monoethyl-ε-caprolactone, monohexyl-ε-caprolactone, dimethyl-ε-caprolactone, din-propyl-ε-caprolactone, di-n-hexyl-ε-caprolactone, trimethyl-ε-caprolactone, triethyl-ε-caprolactone, tri-n-ε-caprolactone, ε-caprolactone, 5-nonyl-oxepan-2-one, 4,4,6-trimethyl-oxepan-2-one, 4,6,6-trimethyl-oxepan-2-one, 5-hydroxymethyl-oxepan-2-one.

8-Membered lactone; ζ-enaotolactone.

Other lactone; lactone, lactide, dilactide, tetramethyl glycoside, 1,5-dioxepan-2-one, t-butylcaprolactone.

### Cyclic lactam;

4-Membered lactam; 4-benzoyloxy-2-azetidinone.

5-Membered lactam; γ-butyrolactam, 2-azabicyclo(2,2,1)hept-5-en-3-one, 5-methyl-2-pyrrolidone.

6-Membered lactam; ethyl 2-piperidone-3-carboxylate.

7-Membered lactam; ε-caprolactam, DL-α-amino-ε-caprolactam.

8-Membered lactam; ω-heptalactam.

### Cyclic carbonate;

Ethylene carbonate, propylene carbonate, 1,2-butylene glycerol carbonate 1,2-carbonate, 4-(methoxymethyl)-1,3-dioxolan-2-one, (chloromethyl)ethylene carbonate, vinylene carbonate, 4,5-dimethyl-1,3-dioxole-2-one, 4-chloromethyl-5-methyl-1,3-dioxole-2-one, 4-vinyl-1,3-dioxolan-2-one, 4,5-diphenyl-1,3-dioxolan-2-one, 4,4-dimethyl-5-methylene-1,3-dioxolan-2-one, 1,3-dioxan-2-one, 5-methyl-5-propyl-1,3-dioxolan-2-one, 5,5-diethyl-1,3-dioxolan-2-one.

The above-mentioned cyclic compounds can be used singly, or two or more thereof can be used as combined.

The cyclic compound preferably used in the present invention is a cyclic lactone or a cyclic lactam. An especially preferred lactone is a cyclic lactone such as ε-caprolactone, α-acetyl-γ-butyrolactone, α-methyl-γ-butyrolactone, γ-valerolactone, and γ-butyrolactone. An especially preferred cyclic lactam is ε-caprolactam, γ-butyrolactam, and DL-α-amino-ε-caprolactam. Even more preferred are ε-caprolactone and ε-caprolactam.

In the case where side chains are introduced by reacting a cyclic compound through ring-cleavage polymerization, the reactive functional group (for example, a hydroxy group) of the cyclic molecule is poorly reactive and therefore, in particular, direct reaction of large molecules would be difficult owing to steric hindrance. In such a case, for example, for reacting the above-mentioned cyclic compound such as caprolactone, a low-molecular compound such as propylene oxide is once reacted with the reactive functional group of the cyclic molecule for hydroxypropylation, and thus a highly reactive functional group is previously introduced, and the method is preferred. Subsequently, side chains are introduced by ring-cleavage polymerization using the above-mentioned cyclic compound. In the case, the method can be employed, and in the case, the hydroxypropylated moiety can also be considered as a side chain.

Any known catalyst can be used with no limitation for the above-mentioned ring cleavage polymerization. For example, usable are organic titanium compounds such as tetramethyl titanate, tetraethyl titanate, tetrapropyl titanate, and tetrabutyl titanate, organic tin compounds such as tin 2-ethylhexanoate, dibutyl tin dilaurate, tin octylate, dibutyl tin oxide, and dibutyl tin acetate, halogenated stannous compounds such as stannous chloride, stannous bromide and stannous iodide, and other various metal acetylacetonate compounds and organic carboxylic acid metal salts. When a certain amount of the above-mentioned catalyst remains after side chain introduction, it may act as a catalyst in reacting with the polymerizable monomer (B), and if so, the polymerization may advance rapidly to cause polymerization failure. Consequently, the amount of the residual catalyst in terms of the metal used in the catalyst is preferably 5000 ppm or less relative to the cyclic polyfunctional monomer (A), more preferably 1000 ppm or less, most preferably 600 ppm or less. Regarding the amount of the residual catalyst, the amount of residual tin can be determined by ICP emission described in the section of Examples.

Further, depending on the kind of the functional group that the compound used for side chain introduction has, a part of the side chain may bond to the functional group of the ring of the other cyclic molecule to form a crosslinked structure.

In the present invention, the cyclic polyfunctional monomer (A) most favorably used is such that the cyclic molecule therein is a β-cyclodextrin and the side chain is introduced in ring cleavage polymerization of ε-caprolactone.

The polymerizable functional group at the terminal of the introduced side chain can be converted to the other polymerizable functional group (for example, the hydroxy group can be converted into an amino group), and for the purpose of controlling the molar number of the hydroxy group and/or the amino group to a desired one, the group can be converted into a nonreactive group.

In the present invention, the affinity of the cyclic polyfunctional monomer (A) for an aqueous phase or an oily phase varies depending on the cyclic molecule used or the side chain as mentioned above.

In the present invention, the hydrophilicity of the cyclic polyfunctional monomer (A) is a case where the monomer is at least partially soluble in water and has a higher affinity in an aqueous phase than in an oily phase, and the oleophilicity of the cyclic polyfunctional monomer (A) is a case where the monomer is at least partially soluble in an organic solvent and has a higher affinity in an oily phase than in an aqueous phase. For example, in the case where the solubility in water at room temperature (25°C) of the component (A) is at least 20 g/l or more, the component (A) is hydrophilic, and in the case where the solubility thereof in an organic solvent solution not soluble in water (for example, in toluene) is 20 g/l or more, the component (A) is oleophilic. Above all, for exhibiting excellent effects, the cyclic polyfunctional monomer (A) that is oleophilic is preferably used.

### <(B) Polymerizable Monomer>

The polymerizable monomer (B) is not specifically limited so far as it is polymerizable with the polymerizable functional group of the component (A), and above all, preferred is at least one selected from the group consisting of (B 1) a polyfunctional isocyanate compound having at least two isocyanate groups (hereinunder this may be referred to as polyfunctional isocyanate compound (B 1), or component (B1)), (B2) a polyol compound having at least two hydroxy groups (hereinunder this may be referred to as polyol compound (B2), or component (B2)), (B3) a polyfunctional amine compound having at least two amino groups (hereinunder this may be referred to as polyfunctional amine compound (B3), or component (B3)), (B4) a compound at least having both a hydroxy group and an amino group (hereinafter this may be referred to as component (B4)), (B5) a melamine-formaldehyde prepolymer compound (hereinafter this may be referred to as component (B5)), (B6) a urea-formaldehyde prepolymer compound (hereinafter this may be referred to as component (B6)), and (B7) a polyfunctional carboxylic acid compound having at least two carboxy groups (hereinafter this may be referred to as polyfunctional carboxylic acid compound (B7), or component (B7)).

The hollow microballoon of the present invention is a hollow microballoon including a resin produced by polymerizing a polymerizing composition that contains the above-mentioned cyclic polyfunctional monomer (A) and polymerizable monomer (B). By selecting the component (A) and the component (B), the resin for the hollow microballoon can be selected. Above all, the resin for the hollow microballoon of the present invention is preferably at least one resin selected from the group consisting of a urethane(urea) resin, a melamine resin, a urea resin or an amide resin, and a copolymer resin of two of more of these resins. The hollow microballoon including the resin selected from these resins can have not only excellent characteristics of hollow microballoon themselves but also CMP polishing pads containing the hollow microballoon can express excellent polishing characteristics.

In the present invention, the urethane(urea) resin is a resin produced by reaction of an isocyanate group and a hydroxy group and/or an amino group and having a urethane bond in the main chain, a resin having a urea bond in the main chain, or a resin having both a urethane bond and a urea bond in the main chain, the melamine resin is a resin where the main chain is formed by polycondensation of a polyfunctional amine containing melamine, and formaldehyde, the urea resin is a resin where the main chain is formed by polycondensation of urea (further including a polyfunctional amine) and formaldehyde, and the amide resin is a resin having an amide bond in the main chain.

Among these, urethane(urea) resin and melamine resin are most preferred for the resin to constitute the hollow microballoon of the present invention, and urethane(urea) resin is most preferred.

Regarding the combination of the cyclic polyfunctional monomer (A) and the polymerizable monomer (B), for example, in the case where the hollow microballoon includes a urethane(urea) resin, the polymerizable functional group of the cyclic polyfunctional monomer (A) is a hydroxy group and/or an amino group, and the polymerizable monomer (B) indispensably contains (B 1) a polyfunctional isocyanate compound and may additionally contain (B2) a polyol compound having at least two hydroxy groups, (B3) a polyfunctional amine compound having at least two amino groups, or (B4) a compound at least having both a hydroxy group and an amino group.

In the case where the hollow microballoon includes a melamine resin, an amino group is selected for the polymerizable functional group of the cyclic polyfunctional monomer (A), and a melamine-formaldehyde prepolymer compound (B5) is selected for the polymerizable monomer (B).

In the case where the hollow microballoon includes a urea resin, an amino group is selected for the polymerizable functional group of the cyclic polyfunctional monomer (A), and a urea-formaldehyde prepolymer compound (B6) is selected for the polymerizable monomer (B).

In the case where the hollow microballoon includes an amide resin, the polymerizable functional group of the cyclic polyfunctional monomer (A) is an amino group, and the polymerizable monomer (B) indispensably contains (B7) a polyfunctional carboxylic acid compound having at least two carboxy groups and, in addition to this, may contain (B3) a polyfunctional amine compound having at least two amino groups.

Hereinunder specific examples of the polymerizable monomer (B) are mentioned.

### <(B1) Polyfunctional isocyanate compound having at least two isocyanate groups>

The polyfunctional isocyanate compound (B1) for use in the present invention may be any one with no limitation, so far as it is a polyfunctional isocyanate compound having at least two isocyanate groups. Above all, a compound having 2 to 6 isocyanate groups in the molecule is preferred, and a compound having 2 to 3 isocyanate groups is more preferred.

The component (B1) may be (B12) a urethane prepolymer containing an unreacted isocyanate group prepared by reaction of a difunctional isocyanate compound to be mentioned below and a difunctional polyol compound or a difunctional amine compound (hereinafter this may be referred to as urethane prepolymer (B12), or component (B12)). The urethane prepolymer (B12) may be any one containing an unreacted isocyanate group can be used with no limitation for the urethane prepolymer (B12).

The component (B1) can be broadly grouped into an aliphatic isocyanate, an alicyclic isocyanate, an aromatic isocyanate, other isocyanate, and the urethane prepolymer (B 12). For the component (B1), one kind of compound can be used, or plural kinds of compounds can be used. In the case where plural kinds of compounds are used, the basis mass is a total amount of the plural kinds of compounds. Specific examples of the isocyanate compounds are listed below.

### (Aliphatic isocyanate)

A difunctional isocyanate monomer (corresponding to a difunctional polyisocyanate compound constituting a urethane prepolymer), such as ethylene diisocyanate, trimethylene diisocyanate, tetramethylene diisocyanate, hexamethylene diisocyanate, octamethylene diisocyanate, nonamethylene diisocyanate, 2,2'-dimethylpentane diisocyanate, 2,2,4-trimethylhexamethylene diisocyanate, decamethylene diisocyanate, butene diisocyanate, 1,3-butadiene-1,4-diisocyanate, 2,4,4-trimethylhexamethylene diisocyanate, 1,6,11-trimethylundecamethylene diisocyanate, 1,3,6-trimethylhexamethylene diisocyanate, 1,8-diisocyanate 4-isocyanate methyloctane, 2,5,7-trimethyl-1,8-diisocyanate 5-isocyanate methyloctane, bis(isocyanatoethyl) carbonate, bis(isocyanatoethyl) ether, 1,4-butylene glycol dipropyl ether-ω,ω'-diisocyanate, lysine diisocyanate methyl ester, and 2,4,4-trimethylhexamethylene diisocyanate.

### (Alicyclic isocyanate)

A difunctional isocyanate monomer (corresponding to a difunctional polyisocyanate compound constituting a urethane prepolymer), such as isophorone diisocyanate, (bicyclo[2.2.1]heptane-2,5-diyl)bismethylene diisocyanate, (bicyclo[2.2.1]heptane-2,6-diyl)bismethylene diisocyanate, 2β,5α-bis(isocyanate)norbornane, 2β,5β-bis(isocyanate)norbornane, 2β,6α-bis(isocyanate)norbornane, 2β,6β-bis(isocyanate)norbornane, 2,6-di(isocyanatomethyl)furan, 1,3-bis(isocyanatomethyl)cyclohexane, dicyclohexylmethane-4,4'-diisocyanate, 4,4-isopropylidene bis(cyclohexyl isocyanate), cyclohexane diisocyanate, methylcyclohexane diisocyanate, dicyclohexyldimethylmethane diisocyanate, 2,2'-dimethyldicyclohexylmethane diisocyanate, bis(4-isocyanate n-butylidene)pentaerythritol, dimer acid diisocyanate, 2,5-bis(isocyanatomethyl)-bicyclo[2,2,1]-heptane, 2,6-bis(isocyanatomethyl)-bicyclo[2,2,1]-heptane, 3,8-bis(isocyanatomethyl)tricyclodecane, 3,9-bis(isocyanatomethyl)tricyclodecane, 4,8-bis(isocyanatomethyl)tricyclodecane, 4,9-bis(isocyanatomethyl)tricyclodexane, 1,5-diisocyanatedecahn, 2,7-diisocyanatedecalin, 1,4-diisocyanatedecalin, 2,6-diisocyanatedecalin, bicyclo[4.3.0]nonane-3,7-diisocyanate, bicyclo[4.3.0]nonane-4,8-diisocyanate, bicyclo[2.2.1]heptane-2,5-diisocyanate, bicyclo[2.2.1]heptane-2,6-diisocyanate, bicyclo[2,2,2]octane-2,5-diisocyanate, bicyclo[2,2,2]octane-2,6-diisocyanate, tricyclo[5.2.1.02.6]decane-3,8-diisocyanate, and tricyclo[5.2.1.02.6]decane-4,9-diisocyanate, and a polyfunctional isocyanate monomer such as 2-isocyanatomethyl-3-(3-isocyanatopropyl)-5-isocyanatomethyl-bicyclo[2,2,1] -heptane, 2-isocyanatomethyl-3-(3-isocyanatopropyl)-6-isocyanatomethyl-bicyclo[2,2,1]-heptane, 2-isocyanatomethyl-2-(3-isocyanatopropyl)-5-isocyanatomethyl-bicyclo[2,2,1]-heptane, 2-isocyanatomethyl-2-(3-isocyanatopropyl)-6-isocyanatomethyl-bicyclo[2,2,1]-heptane, 2-isocyanatomethyl-3-(3-isocyanatopropyl)-5-(2 -isocyanatoethyl) -bicyclo [2,2, 1] - heptane, 2-isocyanatomethyl-3-(3-isocyanatopropyl)-6-(2-isocyanatoethyl)bicyclo[2,2, 1]-heptane, 2-isocyanatomethyl-2-(3-isocyanatopropyl)-5-(2-isocyanatoethyl)-bicyclo[2,2,1]heptane, 2-isocyanatomethyl-2-(3-isocyanatopropyl)-6-(2-isocyanatoethyl)-bicyclo[2,2,1]-heptane, and 1,3,5-tris(isocyanatomethyl)cyclohexane.

### (Aromatic isocyanate)

A difunctional isocyanate monomer (corresponding to a difunctional polyisocyanate compound constituting a urethane prepolymer) such as xylylene diisocyanate (o-, m-, p-), tetrachloro-m-xylylene diisocyanate, methylenediphenyl-4,4'-diisocyanate, 4-chloro-m-xylylene diisocyanate, 4,5-dichloro-m-xylylene diisocyanate, 2,3,5,6-tetrabromo-p-xylylene diisocyanate, 4-methyl-m-xylylene diisocyanate, 4-ethyl-m-xylylene diisocyanate, bis(isocyanatoethyl)benzene, bis(isocyanatopropyl)benzene, 1,3-bis(α,α-dimethylisocyanatomethyl)benzene, 1,4-bis(α,α-dimethylisocyanatomethyl)benzene, α,α,α',α'-tetramethylxylylene diisocyanate, bis(isocyanatobutyl)benzene, bis(isocyanatomethyl)naphthalene, bis(isocyanatomethyl)diphenyl ether, bis(isocyanatoethyl) phthalate, 2,6-diisocyanatomethyl)furan, phenylene diisocyanate (o-, m-, p-), ethylphenylene diisocyanate, isopropylphenylene diisocyanate, dimethylphenylene diisocyanate, diethylphenylene diisocyanate, diisopropylphenylene diisocyanate, trimethylbenzene triisocyanate, benzene triisocyanate, 1,3,5-triisocyanatomethylbenzene, 1,5-naphthalene diisocyanate, methylnaphthalene diisocyanate, biphenyl diisocyanate, 2,4-tolylene diisocyanate, 2,6-tolylene diisocyanate, 4,4'-diphenylmethane diisocyanate, 2,2'-diphenylmethane diisocyanate, 2,4'-diphenylmethane diisocyanate, 3,3'-dimethyldiphenylmethane-4,4'-diisocyanate, bibenzyl-4,4'-diisocyanate, bis(isocyanatophenyl)ethylene, 3,3'-dimethoxybiphenyl-4,4'-diisocyanate, phenylisocyanatomethyl isocyanate, phenylisocyanatoethyl isocyanate, tetrahydronaphthylene diisocyanate, hexahydrobenzene diisocyanate, hexahydrodiphenylmethane-4,4'-diisocyanate, diphenyl ether diisocyanate, ethylene glycol diphenyl ether diisocyanate, 1,3-propylene glycol diphenyl ether diisocyanate, benzophenone diisocyanate, diethylene glycol diphenyl ether diisocyanate, dibenzofuran diisocyanate, carbazole diisocyanate, ethylcarbazole diisocyanate, dichlorocarbazole diisocyanate, 2,4-tolylene diisocyanate, and 2,6-tolylene diisocyanate.

A polyfunctional isocyanate monomer, such as mesitylene triisocyanate, triphenylmethane triisocyanate, polymeric MDI, naphthalene triisocyanate, diphenylmethane-2,4,4'-triisocyanate, 3-methyl-diphenylmethane-4,4',6-triisocyanate, and 4-methyl-diphenylmethane-2,3,4',5,6-pentaisocyanate.

### (Other isocyanate)

The other isocyanate includes a polyfunctional isocyanate having a biuret structure, a uretdione structure or an isocyanurate structure, for which diisocyanates such as hexamethylene diisocyanate or tolylene diisocyanate are main materials (for example, JP2004-534870A discloses a method for modifying a biuret structure, a uretdione structure or an isocyanurate structure of an aliphatic polyisocyanate), and a polyfunctional isocyanate as an adduct with a tri- or higher polyol such as trimethylolpropane (as disclosed in a document (Polyurethane Resin Handbook, edited by Keiji Iwata, published by Nikkan Kogyo Shimbun Co. (1987)).

### ((B12) Urethane prepolymer)

In the present invention, as the urethane prepolymer (B12), preferred are those produced by reacting a difunctional isocyanate compound selected from the component (B1) (compound exemplified as the component (B1)), and (B21) a difunctional polyol compound or (B31) a difunctional amine compound shown below.

Examples of the difunctional polyol compound (B21) are listed below.

### ((B21) Difunctional polyol)

### (Aliphatic alcohol)

A difunctional polyol compound, such as ethylene glycol, diethylene glycol, propylene glycol, dipropylene glycol, butylene glycol, 1,5-dihydroxypentane, 1,6-dihydroxyhexane, 1,7-dihydroxyheptane, 1,8-dihydroxyoctane, 1,9-dihydroxynonane, 1,10-dihydroxydecane, 1,11-dihydroxyundecane, 1,12-dihydroxydodecane, neopentyl glycol, glyceryl monooleate, monoelaidin, polyethylene glycol, 3-methyl-1,5-dihydroxypentane, dihydroxyneopentyl, 2-ethyl-1,2-dihydroxyhexane, 2-methyl-1,3-dihydroxypropane, polyester polyol (a compound having a hydroxy group at both ends obtained by condensation of a polyol and a polybasic acid), polyether polyol (a compound obtained by ring-cleavage polymerization of an alkylene oxide, or a compound obtained by reaction of a compound having at least two active hydrogen-containing groups in the molecule and an alkylene oxide and a modified derivative thereof, having a hydroxy group at both ends of the molecule), polycaprolactone polyol (a compound obtained by ring-cleavage polymerization of ε-caprolactone, having a hydroxy group at both ends of the molecule), polycarbonate polyol (a compound obtained by phosgenation of at least one low-molecular polyol or a compound obtained by interesterification with ethylene carbonate, diethyl carbonate or diphenyl carbonate, having a hydroxy group at both ends of the molecule), and polyacryl polyol (a polyol compound obtained by polymerization of a (meth)acrylate or vinyl monomer, having a hydroxy group at both ends of the molecule).

### (Alicyclic alcohol)

A difunctional polyol compound, such as hydrogenated bisphenol A, cyclobutanediol, cyclopentanediol, cyclohexanediol, cycloheptanediol, cyclooctanediol, cyclohexanedimethanol, hydroxypropylcyclohexanol, tricyclo[5,2,1,02,6]decane-dimethanol, bicyclo[4,3,0]-nonanediol, dicyclohexanediol, tricyclo[5,3,1,13,9]dodecanediol, bicyclo[4,3,0]nonanedimethanol, tricyclo[5,3,1,13,9]dodecane-diethanol, hydroxypropyltricyclo[5,3,1,13,9]dodecanol, spiro[3,4]octanediol, butylcyclohexanediol, 1,1'-bicyclohexylidenediol, 1,4-cyclohexanedimethanol, 1,3-cyclohexanedimethanol, 1,2-cyclohexanedimethanol, and o-dihydroxyxylylene.

### (Aromatic alcohol)

A difunctional polyol compound, such as dihydroxynaphthalene, dihydroxybenzenes, bisphenol A, bisphenol F, xylylene glycol, tetrabromobisphenol A, bis(4-hydroxyphenyl)methane, 1,1-bis(4-hydroxyphenyl)ethane, 1,2-bis(4-hydroxyphenyl)ethane, bis(4-hydroxyphenyl)phenylmethane, bis(4-hydroxyphenyl)diphenylmethane, bis(4-hydroxyphenyl)-1-naphthylmethane, 1,1-bis(4-hydroxyphenyl)-1-phenylethane, 2-(4-hydroxyphenyl)-2-(3-hydroxyphenyl)propane, 2,2-bis(4-hydroxyphenyl)butane, 1,1-bis(4-hydroxyphenyl)butane, 2,2-bis(4-hydroxyphenyl)-3-methylbutane, 2,2-bis(4-hydroxyphenyl)pentane, 3,3-bis(4-hydroxyphenyl)pentane, 2,2-bis(4-hydroxyphenyl)hexane, 2,2 -bis(4-hydroxyphenyl)octane, 2,2 -bis(4-hydroxyphenyl)-4-methylpentane, 2,2-bis(4-hydroxyphenyl)heptane, 4,4-bis(4-hydroxyphenyl)heptane, 2,2-bis(4-hydroxyphenyl)tridecane, 2,2-bis(4-hydroxyphenyl)octane, 2,2-bis(3-methyl-4-hydroxyphenyl)propane, 2,2-bis(3-ethyl-4-hydroxyphenyl)propane, 2,2-bis(3-n-propyl-4-hydroxyphenyl)propane, 2,2-bis(3-isopropyl-4-hydroxyphenyl)propane, 2,2-bis(3-sec-butyl-4-hydroxyphenyl)propane, 2,2-bis(3-tert-butyl-4-hydroxyphenyl)propane, 2,2-bis(3-cyclohexyl-4-hydroxyphenyl)propane, 2,2 -bis (3 - allyl - 4' -hy dr oxyphenyl)p r op ane, 2,2-bis(3-methoxy-4-hydroxyphenyl)propane, 2,2-bis(3,5-dimethyl-4-hydroxyphenyl)propane, 2,2-bis(2,3,5,6-tetramethyl-4-hydroxyphenyl)propane, bis(4-hydroxyphenyl)cyanomethane, 1-cyano-3,3-bis(4-hydroxyphenyl)butane, 2,2-bis(4-hydroxyphenyl)hexafluoropropane, 1,1-bis(4-hydroxyphenyl)cyclopentane, 1,1-bis(4-hydroxyphenyl)cyclohexane, 1,1-bis(4-hydroxyphenyl)cycloheptane, 1,1-bis(3-methyl-4-hydroxyphenyl)cyclohexane, 1,1-bis(3,5-dimethyl-4-hydroxyphenyl)cyclohexane, 1,1-bis(3,5-dichloro-4-hydroxyphenyl)cyclohexane, 1,1-bis(3-methyl-4-hydroxyphenyl)-4-methylcyclohexane, 1,1-bis(4-hydroxyphenyl)-3,3,5-trimethylcyclohexane, 2,2-bis(4-hydroxyphenyl)norbornane, 2,2-bis(4-hydroxyphenyl)adamantane, 4,4'-dihydroxydiphenyl ether, 4,4'-dihydroxy-3,3'-dimethyldiphenyl ether, ethylene glycol bis(4-hydroxyphenyl) ether, 4,4'-dihydroxydiphenyl sulfide, 3,3'-dimethyl-4,4'-dihydroxydiphenyl sulfide, 3,3'-dicyclohexyl-4,4'-dihydroxydiphenyl sulfide, 3,3'-diphenyl-4,4'-dihydroxydiphenyl sulfide, 4,4'-dihydroxydiphenyl sulfoxide, 3,3'-dimethyl-4,4'-dihydroxydiphenyl sulfoxide, 4,4'-dihydroxydiphenyl sulfone, 4,4'-dihydroxy-3,3'-dimethyldiphenyl sulfone, bis(4-hydroxyphenyl) ketone, bis(4-hydroxy-3-methylphenyl) ketone, 7,7'-dihydroxy-3,3',4,4'-tetrahydro-4,4,4',4'-tetramethyl-2,2'-spirobi(2H-1-benzopyran), trans-2,3-bis(4-hydroxyphenyl)-2-butene, 9,9-bis(4-hydroxyphenyl)fluorene, 3,3-bis(4-hydroxyphenyl)-2-butanone, 1,6-bis(4-hydroxyphenyl)-1,6-hexanedione, 4,4'-dihydroxybiphenyl, m-dihydroxyxylylene, p-dihydroxyxylylene, 1,4-bis(2-hydroxyethyl)benzene, 1,4-bis(3-hydroxypropyl)benzene, 1,4-bis(4-hydroxybutyl)benzene, 1,4-bis(5-hydroxypentyl)benzene, 1,4-bis(6-hydroxyhexyl)benzene, 2,2-bis[4-(2"-hydroxyethyloxy)phenyl]propane, hydroquinone and resorcin.

### (Polyester diol)

This includes a difunctional polyol compound obtained by condensation of a polyol and a polybasic acid. Above all, the number-average molecular weight thereof is preferably 400 to 2000, more preferably 500 to 1500, most preferably 600 to 1200.

### (Polyether diol)

This includes a difunctional polyol compound obtained by ring-cleavage polymerization of an alkylene oxide or reaction of a compound having at least two active hydrogen-containing groups in the molecule and an alkylene oxide, or a modified derivative thereof. Above all, the number-average molecular weight thereof is preferably 400 to 2000, more preferably 500 to 1500, most preferably 600 to 1200.

### (Polycaprolactone polyol)

This includes a difunctional polyol compound obtained by ring-cleavage polymerization of ε-caprolactone. Above all, the number-average molecular weight thereof is preferably 400 to 2000, more preferably 500 to 1500, most preferably 600 to 1200.

### (Polycarbonate polyol)

This includes a difunctional polyol compound obtained by phosgenation of at least one low-molecular polyol, or a difunctional polyol compound obtained by interesterification with ethylene carbonate, diethyl carbonate or diphenyl carbonate. Above all, the number-average molecular weight thereof is preferably 400 to 2000, more preferably 500 to 1500, most preferably 600 to 1200.

### (Polyacryl polyol)

This includes a difunctional polyol compound obtained by polymerization of a (meth)acrylate or vinyl monomer.

### ((B31) Difunctional amine compound)

Examples of the difunctional amine compound (B31) are shown below.

### (Aliphatic amine)

A difunctional amine compound such as ethylenediamine, hexamethylenediamine, nonamethylenediamine, undecanemethylenediamine, dodecamethylenediamine, metaxylylenediamine, 1,3-propanediamine, and putrescine.

### (Alicyclic amine)

A difunctional amine compound such as a polyamine, e.g., isophoronediamine and cyclohexyldiamine.

### (Aromatic amine)

A difunctional amine compound such as 4,4'-methylenebis(o-chloroaniline) (MOCA), 2,6-dichloro-p-phenylenediamine, 4,4'-methylenebis(2,3-dichloroaniline), 4,4'-methylenebis(2-ethyl-6-methylaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethylene glycol-di-p-aminobenzoate, polytetramethylene glycol-di-p-aminobenzoate, 4,4'-diamino-3,3',5,5'-tetraethyldiphenylmethane, 4,4'-diamino-3,3'-diisopropyl-5,5'-dimethyldiphenylmethane, 4,4'-diamino-3,3',5,5'-tetraisopropyldiphenylmethane, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 3,3'-diethyl-4,4'-diaminodiphenylmethane, m-xylylenediamine, N,N'-di-sec-butyl-p-phenylenediamine, m-phenylenediamine, p-xylylenediamine, p-phenylenediamine, 3,3'-methylenebis(methyl-6-aminobenzoate), 2-methylpropyl 2,4-diamino-4-chlorobenzoate, isopropyl 2,4-diamino-4-chlorobenzoate, isopropyl 2,4-diamino-4-chlorophenylacetate, di-(2-aminophenyl)thioethyl terephthalate, diphenylmethanediamine, tolylenediamine, and piperazine.

### (Production method for urethane prepolymer (B12))

The urethane prepolymer (B12) is produced by reacting the above-mentioned difunctional isocyanate compound (B21) and a difunctional polyol compound and/or (B31) a difunctional amine compound. In the present invention, the urethane prepolymer (B12) must contain an unreacted isocyanate group. The production method for the (B12) urethane prepolymer having an isocyanate group may be any known method with no limitation, and for example, employable is a production method where the molar number (n5) of the isocyanate group in a difunctional isocyanate compound and the molar number (n6) of the active hydrogen-having group of the difunctional polyol compound (B21) and/or the difunctional amine compound (B31) fall within a range of 1 < (n5)/(n6) < 2.3. In the case where two or more kinds of difunctional isocyanate compounds are used, the molar number (n5) of the isocyanate group is a molar number of the total isocyanate groups of the difunctional isocyanate compounds. In the case where two or more kinds of difunctional polyol compound (B21) and/or difunctional amine compound (B31) are used, the molar number (n6) of the active hydrogen-having group is a molar number of the total active hydrogen of the difunctional polyol compound (B21) and/or the difunctional amine compound (B31). In the present invention where the active hydrogen is a primary amino group, the primary amino group is calculated as one mol. The reason is because, in reacting the second amino group (-NH) in the primary amino group, considerable energy is required (even in a primary amino group, the second -NH is difficult to react), and therefore in the present invention, even in using a difunctional active hydrogen-containing compound having a primary amino group, the primary amino group is calculated as one mol.

Though not specifically limited, the isocyanate equivalent of the urethane prepolymer (B12) (a value calculated by dividing the molecular weight of the urethane prepolymer (B12) by the number of the isocyanate groups in one molecule) is preferably 300 to 5000, more preferably 350 to 3,000, even more preferably 400 to 2,000. In the present invention, the urethane prepolymer (B12) is preferably a linear one produced from a difunctional isocyanate compound and the difunctional polyol compound (B21) and/or the difunctional amine compound (B31), and in that case, both the terminals are isocyanate groups, and the number of the isocyanate groups in one molecule is 2.

Regarding the isocyanate equivalent of the urethane prepolymer (B12), the isocyanate group that the urethane prepolymer (B12) has can be quantitatively determined by a back titration method mentioned below, according to JIS K 7301. First, the urethane prepolymer (B12) produced is dissolved in a dry solvent. Next, di-n-butylamine having a known concentration is added to the dry solvent in an amount obviously excessive over the amount of the isocyanate groups that the urethane prepolymer (B12) has to thereby react all the isocyanate groups of the urethane prepolymer (B12) and di-n-butylamine. Next, di-n-butylamine not consumed (not involved in the reaction) is titered with an acid to determine the amount of the consumed di-n-butylamine. The amount of the consumed di-n-butylamine is the same as the amount of the isocyanate groups that the urethane prepolymer (B 12) has, and therefore, the isocyanate equivalent can be calculated. For example, for a linear urethane prepolymer (B 12) containing isocyanate groups, the number-average molecular weight of the urethane prepolymer (B 12) is two times the isocyanate equivalent. The molecular weight of the urethane prepolymer (B 12) easily matches the value measured by gel permeation chromatography (GPC). In the case where the urethane prepolymer (B12) and a difunctional isocyanate compound are used together, a mixture of the two may be measured according to the above-mentioned method.

Further, it is preferable that the isocyanate content ((I); molar concentration by mass (mol/kg)) in the urethane prepolymer (B12) and the urethane bond content ((U); molar concentration by mass (mol/kg)) in the urethane prepolymer (B 12) satisfy 1 ≤ (U)/(I) ≤ 10. The range may apply to the case where the urethane prepolymer (B 12) and a difunctional isocyanate compound are used together.

The isocyanate content ((I); molar concentration by mass (mol/kg)) is a value calculated by multiplying the reciprocal of the isocyanate equivalent by 1,000. For the urethane bond content in the urethane prepolymer (B12) ((U); molar concentration by mass (mol/kg)), a theoretical value thereof can be determined according to the following method. Specifically, when the content of the isocyanate groups before reaction existing in the difunctional isocyanate compound that constitutes the urethane prepolymer (B 12) is referred to as a total isocyanate content ((aI); molar concentration by mass (mol/kg)), the urethane bond content ((U); molar concentration by mass (mol/kg)) in the urethane prepolymer (B12) is a value calculated by subtracting the isocyanate content ((I); molar concentration by mass (mol/kg)) from the total isocyanate content ((aI); molar concentration by mass (mol/kg)), ((U) = (aI)-(I)).

In production of the urethane prepolymer (B12), as needed, the system may be heated or an urethanation catalyst can be added thereto. Any suitable urethanation catalyst may be used, and as specific examples thereof, the urethanation catalyst to be mentioned hereinunder can be used.

Most preferred examples of the component (B1) for use in the present invention are, from the viewpoint of the strength of the hollow microballoon to be formed and reactivity control, an alicyclic isocyanate such as isophorone diisocyanate, 1,3-bis(isocyanatomethyl)cyclohexane, and (bicyclo[2.2.1]heptane-2,5(2,6)-diyl)bismethylene diisocyanate, an aromatic isocyanate such as 2,4-tolylene diisocyanate, 2,6-tolylene diisocyanate, 4,4'-diphenylmethane diisocyanate, and xylylene diisocyanate (o-, m-, p-), a polyfunctional isocyanate having a biuret structure, a uretdione structure or an isocyanurate structure, for which diisocyanates such as hexamethylene diisocyanate or tolylene diisocyanate are main materials, a polyfunctional isocyanate as an adduct with a tri- or higher polyol, and the urethane prepolymer (B12).

Among these, especially preferred are a polyfunctional isocyanate having a biuret structure, a uretdione structure or an isocyanurate structure, for which diisocyanates such as hexamethylene diisocyanate or tolylene diisocyanate are main materials, a polyfunctional isocyanate as an adduct with a tri- or higher polyol, and the urethane prepolymer (B12).

### <(B2) Polyol compound having at least two hydroxy groups>

The polyol compound (B2) for use in the present invention may be any one with no limitation, so far as it is a compound having at least two hydroxy groups in one molecule. The compound also includes the difunctional polyol compound (B21) for use in production of the urethane prepolymer (B12). The component (B2) is favorably used in hollow microballoon including a urethane(urea) resin. The component (B2) especially favorably used for the hollow microballoon of the present invention is a water-soluble polyol compound.

In the present invention, the water-soluble polyol compound is a compound at least partially soluble in water and having a high affinity in a hydrophilic phase than in a hydrophobic phase. For this, in general, one having a solubility at room temperature (25°C) of at least 1 g/l in a hydrophilic solvent such as water can be selected. Preferably selected is a water-soluble compound having a solubility of 20 g/l or more in a hydrophilic solvent.

These water-soluble polyol compounds are polyfunctional alcohols having at least two hydroxy groups in the molecule, and specific examples thereof include difunctional polyols such as ethylene glycol, diethylene glycol, triethylene glycol, polyethylene glycol, propylene glycol, dipropylene glycol, tripropylene glycol, polypropylene glycol, neopentyl glycol, trimethylene glycol, 1,2-butanediol, 1,3-butanediol, 2,3-butanediol, 1,4-butanediol, 1,5-pentanediol, hexylene glycol, 1,6-hexanediol, and 2-butene-1,4-diol, trifunctional polyols such as glycerin, trimethylolethane, and trimethylolpropane, tetrafunctional polyols such as pentaerythritol, erythritol, diglycerol, diglycerin, and ditrimethylolpropane, pentafunctional polyols such as arabitol, hexafunctional polyols such as dulcitol, sorbitol, mannitol, dipentaerythritol, and triglycerol, heptafunctional polyols such as volemitol, nona-functional polyols such as isomalt, maltitol, isomaltitol, and lactitol, and other water-soluble polymers such as cellulose compound (e.g., methyl cellulose, ethyl cellulose, hydroxyethyl cellulose, ethylhydroxyethyl cellulose, carboxymethyl cellulose, hydroxypropyl cellulose and saponified derivatives thereof), starch, dextrin, cyclodextrin, chitin, chitosan, polyvinyl alcohol, and polyglycerin.

### <(B3) Polyfunctional amine compound having at least two amino groups>

The polyfunctional amine compound (B3) for use in the present invention may be any one with not limitation, so far as it is a monomer having two or more amino groups in one molecule. This includes the difunctional amine compound (B31) used for producing the urethane prepolymer (B12). The component (B3) is favorably used in hollow microballoon including a urethane(urea) resin or an amide resin. The component (B3) especially favorably used in the hollow microballoon of the present invention is a water-soluble polyamine compound.

The preferred solubility of the water-soluble polyamine compound is the same as that of the above-mentioned water-soluble polyol compound. These water-soluble polyamine compounds are polyfunctional amines having at least two amino groups in the molecule, and specific examples thereof include ethylenediamine, propylenediamine, 1,4-diaminobutane, hexamethylenediamine, 1.8-diaminooctane, 1.10-diaminodecane, dipropylenetriamine, bishexamethylenetriamine, tris(2-aminoethyl)amine, piperazine, 2-methylpiperazine, isophoronediamine, diethylenetriamine, triethylenetetramine, tetraethylenepentamine, hydrazine, polyethyleneimines, polyoxyalkyleneamines, and polyethyleneimine.

### <(B4) Compound having at least both a hydroxy group and an amino group>

The compound having at least both a hydroxy group and an amino group for use in the present invention may be any one with no limitation so far as it has at least one hydroxy group and at least one amino group in the molecule. The component (B4) is favorably used in hollow microballoon including a urethane(urea) resin. The component (B4) especially favorably usable herein is a water-soluble compound having both a hydroxy group and an amino group in the molecule.

The preferred solubility of the water-soluble compound having both a hydroxy group and an amino group in the molecule is the same as that of the above-mentioned water-soluble polyol compound. Specific examples of the water-soluble compound having both a hydroxy group and an amino group in the molecule include hydroxyamine, monoethanolamine, 3-amino-1-propanol, 2-amino-2-hydroxymethylpropane-1,3-diol, 2-hydroxyethylethylenediamine, 2-hydroxyethylpropylenediamine, N,N-di-2-hydroxyethylethylenediamine, N,N-di-2-hydroxypropylethylenediamine, N,N-di-2-hydroxypropylpropylenediamne, N-methylethanolamine, diethanolamine, N,N-di-2-hydroxyethylethylenediamine, N,N-di-2-hydroxypropylethylenediamine, and N,N-di-2-hydroxypropylpropylenediamine.

In the present invention, among the components (B2) to (B4), the component (B3) is preferred from the viewpoint of the intensity of the hollow microballoon to be formed and the reaction speed in polymerization.

### <(B5) Melamine formaldehyde prepolymer compound>

The melamine formaldehyde prepolymer compound (B5) is a melamine-formaldehyde precondensation product of melamine and formaldehyde, and can be produced according to an ordinary method. Examples of the melamine-formaldehyde precondensation product of melamine and formaldehyde include methylolmelamine. As the melamine formaldehyde prepolymer compound, commercial products can be appropriately used. For example, the commercial products include Beckamine APM, Beckamine M-3, Beckamine M-3(60), Beckamine MA-S, Beckamine J-101, Beckamine J-1 01LF (by DIC Corporation), Nikaresin S-176, Nikaresin S-260 (by Nippon Carbide Industries Co., Inc.), and Mirbane Resin SM-800 (by Showa Denko K.K.).

The component (B5) is favorably used in hollow microballoon including a melamine resin.

### <(B6) Urea formaldehyde prepolymer compound>

The urea formaldehyde prepolymer compound (B6) is a urea-formaldehyde precondensation product of urea and formaldehyde, and can be produced according to an ordinary method. As the urea formaldehyde prepolymer compound, commercial products can be appropriately used. For example, the commercial products include 8HSP (by Showa Denko K.K.).

The component (B6) is favorably used in hollow microballoon including a urea resin.

### <(B7) Polyfunctional carboxylic acid compound having at least two carboxy groups>

The polyfunctional carboxylic acid compound (B7) is preferably a dicarboxylic acid compound, and the dicarboxylic acid compound includes succinic acid, adipic acid, sebacic acid, dodecenylsuccinic acid, azelaic acid, sebacic acid, dodecanedicarboxylic acid, octadecanedicarboxylic acid, dodecenylsuccinic acid, pentadecenylsuccinic acid, octadecenylsuccinic acid, maleic acid, fumaric acid, and other alkenylenedicarboxylic acids, and decylsuccinic acid, dodecylsuccinic acid, octadecylsuccinic acid, phthalic acid, isophthalic acid, terephthalic acid, naphthalenedicarboxylic acid, and the like.

The component also includes a dicarboxylic acid dihalide. Specific examples thereof include aliphatic dicarboxylic acid dihalides, alicyclic dicarboxylic acid dihalides, and aromatic dicarboxylic acid dihalides.

Examples of aliphatic dicarboxylic acid dihalides include oxalic acid dichloride, malonic acid dichloride, succinic acid dichloride, fumaric acid dichloride, glutaric acid dichloride, adipic acid dichloride, muconic acid dichloride, sebacic acid dichloride, nonanoic acid dichloride, undecanoic acid dichloride, oxalic acid dibromide, malonic acid dibromide, succinic acid dibromide, and fumaric acid dibromide.

Examples of alicyclic dicarboxylic acid dihalides include 1,2-cyclopropanedicarboxylic acid dichloride, 1,3-cyclobutanedicarboxylic acid dichloride, 1,3-cyclopentanedicarboxylic acid dichloride, 1,3-cyclohexanedicarboxylic acid dichloride, 1,4-cyclohexanedicarboxylic acid dichloride, 1,3-cyclopentanedicarboxylic acid dichloride, 1,2-cyclopropanedicarboxylic acid dibromide, and 1,3-cyclobutanedicarboxylic acid dibromide.

Examples of aromatic dicarboxylic acid dihalides include phthalic acid dichloride, isophthalic acid dichloride, terephthalic acid dichloride, 1,4-naphthalenedicarboxylic acid dichloride, 1,5-(9-oxofluorene)dicarboxylic acid dichloride, 1,4-anthracenedicarboxylic acid dichloride, 1,4-anthracenedicarboxylic acid dichloride, 2,5-biphenyldicarboxylic acid dichloride, 1,5-biphenylenedicarboxylic acid dichloride, 4,4'-biphenyldicarbonyl chloride, 4,4'-methylene-dibenzoic acid dichloride, 4,4'-isopropylidene-dibenzoic acid dichloride, 4,4'-bibenzyldicarboxylic acid dichloride, 4,4'-stilbenedicarboxylic acid dichloride, 4,4'-tolandicarboxylic acid dichloride, 4,4'-carbonyldibenzoic acid dichloride, 4,4'-oxydibenzoic acid dichloride, 4,4'-sulfonyldibenzoic acid dichloride, 4,4'-dithiodibenzoic acid dichloride, p-phenylenediacetic acid dichloride, 3,3'-p-phenylenedipropionic acid dichloride, phthalic acid dibromide, isophthalic acid dibromide, and terephthalic acid dibromide.

In the present invention, preferred examples of the component (B7) are dicarboxylic acid dihalides, from the viewpoint of polymerization speed.

The polymerizable composition in the present invention may contain polyrotaxane, but from the viewpoint of bettering the handleability in producing hollow microballoon, it is preferable not to contain a large amount of polyrotaxane. The content of polyrotaxane in the polymerizable composition is preferably 10% by mass or less, more preferably 5% by mass or less, even more preferably 0% by mass.

### <Production method for hollow microballoon>

Regarding the production method for hollow microballoon of the present invention, any known method is employable with no limitation for preparing a resin by polymerizing the polymerizable composition containing the component (A) and the component (B). For example, employable is a method of preparing microballoon according to a known method using emulsions by an aqueous phase and an oily phase, such as interfacial polymerization, coacervation or in-situ polymerization, followed by removing the liquid from the inside to produce hollow microballoon.

Specifically, the hollow microballoon of the present invention can be produced, for example, according to the following methods, to which, however, the present invention is not limited. The cyclic polyfunctional monomer (A) varies whether it is hydrophilic or oleophilic, depending on the kind and the introduction amount of the selected cyclic molecule and the side chains, and therefore, after the oleophilicity of the cyclic polyfunctional monomer (A) used has been confirmed, it may be dissolved in an aqueous phase or an oily phase in use thereof.

### <Case where the hollow microballoon includes a urethan(urea) resin or an amide resin>

In the case where the hollow microballoon includes a urethan(urea) resin or an amide resin, these may be formed by interfacial polymerization. In the case of interfacial polymerization, after an oil-in-water (O/W) emulsion (hereinafter this may be referred to as O/W emulsion), or a water-in-oil (W/O) emulsion (hereinafter this may be referred to as W/O emulsion) has been prepared to be the polymerizable composition containing the component (A) and the component (B), the polymerizable composition is polymerized at the interface to produce hollow microballoon. In the present invention, any of an O/W emulsion or a W/O emulsion is selectable, but an O/W emulsion is preferred since interfacial polymerization of such an O/W emulsion can efficiently produce hollow microballoon. Hereinunder an interfacial polymerization of an O/W emulsion is exemplified. Except "case of an amide resin", the following is an exemplification for a urethane(urea) resin.

The polymerization method of an O/W emulsion is briefly divided into the following, a first step: a step of preparing (a) an oily phase at least containing the component (B1) (in the case of an amide resin, the component (B7)) and an organic solvent (hereinafter also referred to as component (a)), a second step: a step of preparing (b) an aqueous phase containing an emulsifier (hereinafter also referred to as component (b)), a third step: a step of mixing and stirring the component (a) and the component (b) to prepare an O/W emulsion in which the aqueous phase is a continuous phase and the oily phase is a disperse phase, a fourth step: a step of adding a hydrophilic compound selected from the components (B2) to (B4) (in the case of an amide resin, the components (B3) to (B4) (the component (B4) in the "case of an amide resin" is limited to only the component (B4) having at least two amino groups - the same shall apply hereinunder)) to the O/W emulsion to give the polymerizable composition containing the component (A) and the component (B), and the polymerizable composition is polymerized on the O/W emulsion interface to form a resin film to give microballoon, thereby producing a microballoon dispersion where the microballoon is dispersed, a fifth step: a step of separating the microballoon from the microballoon dispersion, and a sixth step: a step of removing the organic solvent solution from inside of the microballoon to produce hollow microballoon. Here, in the case where the cyclic polyfunctional monomer (A) in the present invention is oleophilic, the cyclic polyfunctional monomer (A) may be uniformly dissolved in the component (a) in the first step, and in the case where the cyclic polyfunctional monomer (A) is hydrophilic, the cyclic polyfunctional monomer (A) may be added to the O/W emulsion along with the hydrophilic compound selected from the components (B2) to (B4) (in the case of an amide resin, the components (B3) and (B4)) in the fourth step. In that manner, the cyclic polyfunctional monomer (A) can react with the component (B1) (in the case of an amide resin, the component (B7)).

### First step:

The first step is a step of preparing the (a) oily phase at least containing the component (B1) (in the case of an amide resin, the component (B7)) and an organic solvent which is to be a disperse phase in the O/W emulsion.

The step is a step of dissolving the component (B1) (in the case of an amide resin, the component (B7)) in an organic solvent to be mentioned below to prepare an oily phase, and the component may be dissolved in a known method to prepare a uniform solution. In the case where the cyclic polyfunctional monomer (A) is oleophilic, the component (A) may be dissolved in a solution of the above-mentioned oily phase to give a uniform solution of the component (a).

In the case where the hollow microballoon includes a urethane(urea) resin, a preferred amount to be used of the component (B1) is 0.1 to 50 parts by mass relative to 100 part by mass of the organic solvent, more preferably 0.5 to 20 parts by mass, even more preferably 1 to 10 parts by mass. In the case where the molar number of all the active hydrogen group-containing compounds of the component (A) and the components (B2) to (B4) is referred to as (n2), relative to the molar number (n1) of the isocyanate groups that the component (B1) has, n1 and n2 preferably fall within a range of 0.5 ≤ (n1)/(n2) ≤ 2.

In the case where the hollow microballoon includes an amide resin, a preferred amount to be used of the component (B7) is 0.1 to 50 parts by mass relative to 100 part by mass of the organic solvent, more preferably 0.5 to 20 parts by mass, even more preferably 1 to 10 parts by mass. In the case where the molar number of all the active hydrogen group-containing compounds of the component (A) and the components (B3) to (B4) is referred to as (n4), relative to the molar number (n3) of the carboxylic acid groups that the component (B7) has, n3 and n4 preferably fall within a range of 0.5 ≤ (n3)/(n4) ≤ 2.

A catalyst to be mentioned below may be added to the component (a) for the purpose of promoting the interfacial polymerization reaction.

### Second step:

The second step is a step of preparing the (b) aqueous phase containing an emulsifier and water, which is to be a continuous phase in the O/W emulsion.

The step is a step of dissolving an emulsifier to be mentioned below in water to prepare an aqueous phase, and an emulsifier may be dissolved in a known method to give a uniform solution.

In the present invention, the amount to be used of the emulsifier is 0.01 to 20 parts by mass relative to 100 parts by mass of water, preferably 0.1 to 10 parts by mass. Within the range, aggregation of the liquid drops of the disperse phase in the O/W emulsion can be prevented, and hollow microballoon having a uniform average particle size is easy to produce.

A catalyst to be mentioned below may be added to the component (b) for the purpose of promoting the interfacial polymerization reaction.

### Third step:

The third step is a step of mixing and stirring the component (a) prepared in the first step and the component (b) prepared in the second step to prepare an O/W emulsion in which the component (a) is a disperse phase and the component (b) is a continuous phase.

In the present invention, the method of mixing and stirring the component (a) and the component (b) to give an O/W emulsion may be a method of mixing and stirring them in consideration of the particle size of the hollow microballoon to be produced and according to an appropriate known method.

In particular, a method of preparing an O/W emulsion is preferably employed, in which the component (a) and the component (b) are, after having been mixed, dispersed by stirring using a known dispersing machine such as a high-speed shear mode, a friction mode, a high-pressure jet mode or an ultrasonic wave mode. Among these, a high-speed shear mode is preferred. In the case where a high-speed shear mode dispersing machine is used, the rotation number is preferably 500 to 20,000 rpm, more preferably 1,000 to 10,000 rpm. The dispersion time is preferably 0.1 to 60 minutes, more preferably 0.5 to 30 minutes. The dispersion temperature is preferably 10 to 40°C.

In the present invention, the ratio by weight of the component (a) to the component (b) is preferably such that the component (a) is 1 to 100 parts by mass relative to 100 parts by mass of the component (b), more preferably 2 to 90 parts by mass, even more preferably 5 to 50 parts by mass. Within the range, a good emulsion can be produced.

### Fourth step:

The fourth step is a step of adding at least one compound selected from the components (B2) to (B4) (in the case of an amide resin, the components (B3) to (B4)) to the O/W emulsion to give the polymerizable composition containing the component (A) and the component (B), and the resultant polymerizable composition is polymerized on the O/W emulsion interface to form a resin film to give microballoon, thereby producing a microballoon dispersion where the microballoon is dispersed. In the case where the cyclic polyfunctional monomer (A) is hydrophilic, it may be added to the O/W emulsion along with at least one compound selected from the components (B2) to (B4) (in the case of an amide resin, the components (B3) to (B4)) in the fourth step.

In the case where the components (B2) to (B4) (in the case of an amide resin, the components (B3) to (B4)) and the component (A) are added to the O/W emulsion, they may be directly added thereto or may be previously dissolved in water prior to addition.

In the case where the components are dissolved in water, preferably, the amount of water to be used is in a range of 50 to 10,000 parts by mass relative to 100 parts by mass of the total amount of the components (B2) to (B4) (in the case of an amide resin, the components (B3) to (B4)) and the component (A),

The reaction temperature is not specifically limited so far as the O/W emulsion is not broken at the temperature, and preferably the reaction is carried out within a range of 5 to 70°C. The reaction time is not also specifically limited, so far as the W/O emulsion can be formed within the time, and is generally selected from a range of 0.5 to 24 hours.

### Fifth step

The fifth step is a step of separating the microballoon from the microballoon dispersion. The separation method of separating the microballoon from the microballoon dispersion is not specifically limited, and can be selected from ordinary separation methods. For example, filtration or centrifugal separation is employed.

### Sixth step

The sixth step is a step of removing the oily phase from inside of the microballoon obtained in the fifth step to give hollow microballoon. The method for removing the oily phase from the microballoon is not specifically limited, and can be selected from ordinary separation methods. For example, a circulation air drier, a spray drier, a fluidized bed drier, or a vacuum drier can be used. The temperature at drying is preferably 40 to 250°C, more preferably 50 to 200°C.

### <Case where the hollow microballoon includes a melamine resin or a urea resin>

Also in the case where the hollow microballoon includes a melamine resin or a urea resin, these may be formed by interfacial polymerization or in-situ polymerization after an O/W emulsion has been prepared. Hereinunder specific examples are shown, but the production method in the present invention is not limited thereto.

The polymerization method of an O/W emulsion for the hollow microballoon includes a melamine resin or a urea resin is briefly divided into the following, a first step: a step of preparing (c) an oily phase containing an organic solvent (hereinafter also referred to as component (c)), a second step: a step of preparing (d) an aqueous phase containing an emulsifier (hereinafter also referred to as component (d)), a third step: a step of mixing and stirring the component (c and the component (d) to prepare an O/W emulsion in which the aqueous phase is a continuous phase and the oily phase is a disperse phase, a fourth step: a step of adding the component (B5) or the component (B6) to the O/W emulsion to give the polymerizable composition containing the component (A) and the component (B), and the resultant polymerizable composition is polymerized on the O/W emulsion interface to form a resin phase, thereby producing a microballoon dispersion where microballoon is dispersed, a fifth step: a step of separating the microballoon from the microballoon dispersion, and a sixth step: a step of removing the organic solvent solution from inside of the microballoon to produce hollow microballoon. Here, in the case where the cyclic polyfunctional monomer (A) in the present invention is oleophilic, it may be uniformly dissolved in the oily phase in the first step, and in the case where the cyclic polyfunctional monomer (A) is hydrophilic, it may be added along with the component (B5) or the component (B6). In that manner, the cyclic polyfunctional monomer (A) can be taken into the resin that constitutes the hollow microballoon along with the component (B5) or the component (B6).

### First step:

The first step is a step of preparing the (c) oily phase containing an organic solvent, which is to be a disperse phase in the O/W emulsion.

In this step where the cyclic polyfunctional monomer (A) is oleophilic, the component (A) may be dissolved in the above-mentioned organic solvent to prepare a uniform oily phase.

On the other hand, in the case where the cyclic polyfunctional monomer (A) is hydrophilic, the component (A) is not dissolved in the organic solvent, and therefore the organic solvent may be merely an oily phase.

### Second step:

The second step is a step of preparing the (d) aqueous phase containing an emulsifier and water, which is to be a continuous phase in the O/W emulsion and controlling the pH.

The step includes a step of dissolving an emulsifier to be mentioned below in water followed by pH control. For pH control or the like, a known method may be used.

In the present invention, the amount to be used of the emulsifier is 0.01 to 20 parts by mass relative to 100 parts by mass of water, preferably 0.1 to 10 parts by mass. Within the range, aggregation of the liquid drops of the disperse phase in the O/W emulsion can be prevented, and hollow microballoon having a uniform average particle size is easy to produce.

Preferably, the pH controlled to be less than 7, more preferably within a range of 3.5 to 6.5, most preferably 4.0 to 5.5. Falling within the pH range, polymerization of the component (B5) or the component (B6) to be mentioned below can be promoted.

### Third step:

The third step is a step of mixing and stirring the component (c) prepared in the first step and the component (d) prepared in the second step to prepare an O/W emulsion in which the component (c) is a disperse phase and the component (d) is a continuous phase.

In the present invention, the method of mixing and stirring the component (c) and the component (d) to give an O/W emulsion may be a method of mixing and stirring them in consideration of the particle size of the hollow microballoon to be produced and according to an appropriate known method. In addition, in the step of preparing the O/W emulsion, the temperature and the pH can be controlled.

In particular, a method of preparing an O/W emulsion is preferably employed, in which the component (c) and the component (d) are, after having been mixed, dispersed by stirring using a known dispersing machine such as a high-speed shear mode, a friction mode, a high-pressure jet mode or an ultrasonic wave mode. Among these, a high-speed shear mode is preferred. In the case where a high-speed shear mode dispersing machine is used, the rotation number is preferably 500 to 20,000 rpm, more preferably 1,000 to 10,000 rpm. The dispersion time is preferably 0.1 to 60 minutes, more preferably 0.5 to 30 minutes. The dispersion temperature is preferably 20 to 90°C.

In the present invention, the ratio by weight of the component (c) to the component (d) is preferably such that the component (c) is 1 to 100 parts by mass relative to 100 parts by mass of the component (d), more preferably 2 to 90 parts by mass, even more preferably 5 to 50 parts by mass. Within the range, a good emulsion can be produced.

### Fourth step:

The fourth step is a step of adding the component (B5) or the component (B6) to the O/W emulsion to give the polymerizable composition containing the component (A) and the component (B), and the resultant polymerizable composition is polymerized on the O/W emulsion interface to form a resin film to give microballoon, thereby producing a microballoon dispersion where the produced microballoon is dispersed.

The amount to be used of the component (B5) or the component (B6) is not specifically limited, but for forming good microballoon, the amount is preferably 0.5 to 50 parts by mass relative to 100 parts by mass of the organic solvent used in the first step, more preferably 1 to 20 parts by mass.

In the case where the cyclic polyfunctional monomer (A) is hydrophilic, it may be added to the O/W emulsion along with the component (B5) or the component (B6) in the fourth step.

In the case where the components (B5) or the component (B6), and the component (A) are added to the O/W emulsion, they may be directly added thereto or may be previously dissolved in water prior to addition.

In the case where the components are dissolved in water, preferably, the amount of water to be used is in a range of 50 to 10,000 parts by mass relative to 100 parts by mass of the total amount of the components (B5) or the component (B6), and the component (A).

The pH of the aqueous phase of a continuous phase may be controlled in the second step, or after the component (B5) or the component (B6) is added in the fourth step, it may be controlled. The pH of the aqueous phase of a continuous phase is preferably at least less than 7. Regarding the preferred reaction temperature, the reaction is carried out preferably in a range of 40 to 90°C. The reaction time is preferably 1 to 48 hours.

### Fifth step, Sixth step

The fifth step and the sixth step are the same as in the case where the hollow microballoon includes a urethane(urea) resin (or polyamide resin).

### <Preferred formulation ratio>

The content of the cyclic polyfunctional monomer (A) in the polymerizable composition for use in producing the resin to constitute the hollow microballoon of the present invention is preferably 1 to 50 parts by mass relative to 100 parts by mass of the total of the cyclic polyfunctional monomer (A) and the polymerizable monomer (B). When the composition contains the cyclic polyfunctional monomer (A) in that ratio, it can express excellent durability and excellent properties. In the case where the hollow microballoon is used for a CMP polishing pad, the pad can express not only excellent durability but also excellent polishing characteristics.

Especially more preferably, the component (A) is 2 to 40 parts by mass relative to 100 parts by mass of the total of the cyclic polyfunctional monomer (A) and the polymerizable monomer (B), and even more preferably the component (A) is 3 to 30 parts by mass.

The content of the component (A) can be determined by analysis such as solid NMR of the polymerized resin, but in general, it is determined from the amount thereof used. In the case of an O/W emulsion, it is considered that all the amount used of the component (A) and the component (B) contained in the oily phase can be contained in the resin constituting the hollow microballoon. On the other hand, it is also considered that all the amount used of the component (A) and the component (B) added to an aqueous phase can be contained in the resin constituting the hollow microballoon, so far as the amount used falls within the above-mentioned preferred range. The components whose amount added falls without the preferred range, that is, the component (B) in the fourth step and the component (A) added in an amount falling outside the preferred range can be determined by identifying the component (B) and the component (A) having remained in the form not involved in polymerization by analysis of the aqueous phase after the reaction. Taking these into consideration, it is possible to define the amount of the monomer involved in formation of the hollow microballoon.

Namely, in other words, the content of the component (A) in the resin constituting the hollow microballoon of the present invention is preferably 1 to 50 parts by mass relative to 100 parts by mass of the total content of the component (A) and the component (B), more preferably 2 to 40 parts by mass, even more preferably 3 to 30 parts by mass.

Falling within the above-mentioned range, microballoon can be efficiently produced in emulsion.

The components used in the present invention are described below.

### <Emulsifier>

In the present invention, as the emulsifier for the component (b) or the component (d), usable is a dispersant, a surfactant or a combination of these.

Examples of the dispersant include polyvinyl alcohol and modified derivatives thereof (for example, anion-modified polyvinyl alcohol), cellulosic compounds (for example, methyl cellulose, ethyl cellulose, hydroxyethyl cellulose, ethylhydroxyethyl cellulose, carboxymethyl cellulose, hydroxypropyl cellulose and saponified derivatives thereof), polyacrylic acid amide and derivatives thereof, ethylene-vinyl acetate copolymer, styrene-maleic anhydride copolymer, ethylene-maleic anhydride copolymer, isobutylene-maleic anhydride copolymer, polyvinyl pyrrolidone, ethylene-acrylic acid copolymer, vinyl acetate-acrylic acid copolymer, sodium polyacrylate, potassium polyacrylate, ammonium polyacrylate, partially neutralized derivatives of polyacrylic acid, sodium acrylate-acrylate copolymer, carboxymethyl cellulose, casein, gelatin, dextrin, chitin, chitosan, starch derivatives, gum arabic and sodium alginate.

Preferably, these dispersants do not react with or extremely hardly react with the polymerizable composition used in the present invention. Therefore, it is desirable that those having a reactive amino group in the molecular chain, such as gelatin, are previously processed for treatment to lose reactivity.

The surfactant includes an anionic surfactant, a cationic surfactant, an ampholytic surfactant, a nonionic surfactant, and the like. Two or more kinds of surfactants can be used as combined.

The anionic surfactant includes a carboxylic acid or a salt thereof, a sulfate ester salt, a salt of a carboxymethylated substance, a sulfonic acid salt and a phosphate ester salt.

The carboxylic acid or a salt thereof includes a saturated or unsaturated fatty acid having 8 to 22 carbon atoms, or a salt thereof, and specific examples include capric acid, lauric acid, myristic acid, palmitic acid, stearic acid, arachidic acid, behenic acid, oleic acid, linolic acid, ricinoleic acid, and a mixture of higher fatty acids obtained by saponifying palm oil, palm kernel oil, rice bran oil or beef tallow. The salt includes salts of the above with sodium, potassium, ammonium, alkanolamine, or the like.

The sulfate ester salt includes a higher alcohol sulfate ester salt (a sulfate ester salt of an aliphatic alcohol having 8 to 18 carbon atoms), a higher alkyl ether sulfate ester salt (a sulfate ester salt of an ethylene oxide adduct of an aliphatic alcohol having 8 to 18 carbon atoms), a sulfated oil (an unsaturated oil or fat or an unsaturated wax is directly sulfated and neutralized), a sulfated fatty acid ester (a lower alcohol ester of an unsaturated fatty acid is sulfated and neutralized), and a sulfated olefin (an olefin having 12 to 18 carbon atoms is sulfated and neutralized). The salt includes a sodium salt, a potassium salt, an ammonium salt and an alkanolamine salt.

Specific examples of the higher alcohol sulfate ester salt include an octyl alcohol sulfate ester salt, a decyl alcohol sulfate ester salt, a lauryl alcohol sulfate ester salt, a stearyl alcohol sulfate ester salt, and a sulfate ester salt of an alcohol synthesized in an oxo method (Oxocol 900, tridecanol: by Kyowa Hakko Co., Ltd.).

Specific examples of the higher alkyl ether sulfate ester salt include a lauryl alcohol ethylene oxide (2 mols) adduct sulfate ester salt, and an octyl alcohol ethylene oxide (3 mols) adduct sulfate ester salt.

Specific examples of the sulfated oil include sodium, potassium, ammonium or alkanolamine salts of sulfated castor oil, peanut oil, olive oil, rapeseed oil, beef tallow or mutton tallow.

Specific examples of the sulfated fatty acid ester include sodium, potassium, ammonium or alkanolamine salts of sulfated butyl oleate or butyl ricinoleate.

The salt of a carboxymethylated compound includes a salt of a carboxymethylated aliphatic alcohol having 8 to 18 carbon atoms, and a salt of a carboxymethylated ethylene oxide adduct of an aliphatic alcohol having 8 to 16 carbon atoms.

Specific examples of the salt of a carboxymethylated aliphatic alcohol include an octyl alcohol carboxymethylated sodium salt, a decyl alcohol carboxymethylated sodium salt, a lauryl alcohol carboxymethylated sodium salt, and a tridecanol carboxymethylated sodium salt.

Specific example of the aliphatic alcohol ethylene oxide adduct carboxymethylated salt include an octyl alcohol ethylene oxide (3 mols) adduct carboxymethylated sodium salt, a lauryl alcohol ethylene oxide (4 mols) adduct carboxymethylated sodium salt, and a tridecanol ethylene oxide (5 mols) adduct carboxymethylated sodium salt.

The sulfonate salt includes an alkylbenzene sulfonate salt, an alkylnaphthalene sulfonate salt, a sulfosuccinic acid diester-type salt, an α-olefin sulfonate salt, an Igepon T-type salt, and other aromatic ring-containing compound sulfonate salts.

Specific examples of the alkylbenzene sulfonate salt include sodium dodecylbenzene sulfonate salt.

Specific examples of the alkylnaphthalene sulfonate salt include dodecylnapthalene sulfonate sodium salt.

Specific examples of the sulfosuccinic acid diester-type salt include sulfosuccinic acid di-2-ethylhexyl ester sodium salt.

The sulfonic acid salt of an aromatic ring-containing compound include an alkylated diphenyl ether mono- or di-sulfonate salt, a styrenated phenolsulfonate salt, and the like.

The phosphate ester salt includes a higher alcohol phosphate ester salt, and a higher alcohol ethylene oxide adduct phosphate ester salt.

Specific examples of the higher alcohol phosphate ester salt include lauryl alcohol phosphoric acid monoester disodium salt, and lauryl alcohol phosphoric acid diester sodium salt.

Specific examples of the higher alcohol ethylene oxide adduct phosphate ester salt include oleyl alcohol ethylene oxide (5 mols) adduct phosphoric acid monoester disodium salt.

The cationic surfactant includes a quaternary ammonium salt-type surfactant, an amine salt-type surfactant, and the like.

The quaternary ammonium salt-type surfactant includes reaction products of a tertiary amine and a quaternizing agent (e.g., alkylating agent such as methyl chloride, methyl bromide, ethyl chloride, benzyl chloride and dimethyl sulfate, and ethylene oxide), such as lauryltrimethylammonium chloride, didecyldimethylammonium chloride, dioctyldimethylammonium bromide, stearyltrimethylammonium bromide, lauryldimethylbenzylammonium chloride (benzalkonium chloride), cetylpyridinium chloride, polyoxyethylene trimethylammonium chloride, and stearamidoethyldiethylmethylammonium methosulfate.

The amine-type surfactant is obtained by neutralizing a mono- to triamine with an inorganic acid (e.g., hydrochloric acid, nitric acid, sulfuric acid, hydroiodic acid) or an organic acid (e.g., acetic acid, formic acid, oxalic acid, lactic acid, gluconic acid, adipic acid, or alkylphosphoric acid). Examples of the primary amine salt-type surfactant includes an inorganic acid salt or an organic acid salt of an aliphatic higher amine (higher amine such as laurylamine, stearylamine, cetylamine, hardened beef tallow amine, or rosin amine), and a higher fatty acid (e.g., stearic acid or oleic acid) salt of a lower amine.

Examples of the secondary amine salt-type surfactant include an inorganic acid salt or an organic acid salt of an aliphatic amine ethylene oxide adduct.

Examples of the tertiary amine salt-type surfactant include an inorganic acid salt or an organic acid salt of an aliphatic amine (e.g., triethylamine, ethyldimethylamine, N,N,N',N'-tetramethylethylenediamine), an aliphatic amine ethylene oxide adduct, an alicyclic amine (e.g., N-methylpyrrolidine, N-methylpiperidine, N-methylhexamethyleneimine, N-methylmorpholine, 1,8-diazabicyclo(5,4,0)-7-undecene), or a nitrogen-containing heterocyclic aromatic amine (e.g., 4-dimethylaminopyridine, N-methylimidazole, 4,4'-dipyridyl), and an inorganic acid salt or an organic acid salt of a tertiary amine such as triethanolamine monostearate, and stearamidoethyldiethylmethylethanolamine.

The ampholytic surfactant includes a carboxylate salt-type ampholytic surfactant, a sulfate ester salt-type ampholytic surfactant, a sulfonate salt-type ampholytic surfactant, a phosphate ester salt-type ampholytic surfactant, and the like. The carboxylate salt-type ampholytic surfactant includes an amino acid-type ampholytic surfactant and a betaine-type ampholytic surfactant.

The carboxylate salt-type ampholytic surfactant includes an amino acid-type ampholytic surfactant, a betaine-type ampholytic surfactant, an imidazoline-type ampholytic surfactant, and the like. Among these, the amino acid-type ampholytic surfactant is an ampholytic surfactant having an amino group and a carboxy group in the molecule, and specifically, examples thereof include an alkylaminopropionate-type ampholytic surfactant (e.g., sodium stearylaminopropionate, sodium laurylaminopropionate), and an alkylaminoacetate-type ampholytic surfactant (e.g., sodium laurylaminoacetate).

The betaine-type ampholytic surfactant is an ampholytic surfactant having a quaternary ammonium salt-type cationic moiety and a carboxylate-type anionic moiety in the molecule, and examples thereof include an alkyldimethylbetaine (e.g., stearyl dimethylaminoacetate betaine, lauryl dimethylaminoacetate betaine), an amidobetaine (e.g., coconut oil fatty acid amide propylbetaine), and an alkyldihydroxyalkyl betaine (e.g., lauryldihydroxyethyl betaine).

Examples of the imidazoline-type ampholytic surfactant include 2-undecyl-N-carboxymethyl-N-hydroxyethylimidazolinium betaine.

Examples of other ampholytic surfactants include glycine-type ampholytic surfactants such as sodium lauroylglycine, sodium lauryldiaminoethylglycine, lauryldiaminoethylglycine hydrochloride, and dioctyldiaminoethylglycine hydrochloride, and sulfobetaine-type ampholytic surfactants such as pentadecylsulfotaurine.

The nonionic surfactant includes an alkylene oxide adduct-type nonionic surfactant, a polyalcohol-type nonionic surfactant, and the like.

The alkylene oxide adduct-type nonionic surfactant is obtained by reacting a polyalkylene glycol, which is obtained by directly adding an alkylene oxide to a higher alcohol, a higher fatty acid or an alkylamine, ets., or by adding an alkylene oxide to a glycol, with a higher fatty acid or the like, or is obtained by adding an alkylene oxide to an esterified product, which is obtained by reacting a higher fatty acid with a polyalcohol, or by adding an alkylene oxide to a higher fatty acid amide.

Examples of the alkylene oxide include ethylene oxide, propylene oxide and butylene oxide.

Specific examples of the alkylene oxide adduct-type nonionic surfactant include an oxyalkylene alkyl ether (e.g., octyl alcohol ethylene oxide adduct, lauryl alcohol ethylene oxide adduct, stearyl alcohol ethylene oxide adduct, oleyl alcohol ethylene oxide adduct, lauryl alcohol ethylene oxide propylene oxide block adduct), a polyoxyalkylene higher fatty acid ester (e.g., stearyl acid ethylene oxide adduct, lauryl acid ethylene oxide adduct), a polyoxyalkylene polyalcohol higher fatty acid ester (e.g., polyethylene glycol lauryl acid diester, polyethylene glycol oleic acid diester, polyethylene glycol stearic acid diester), a polyoxyalkylene alkyl phenyl ether (e.g., nonylphenol ethylene oxide adduct, nonylphenol ethylene oxide propylene oxide block adduct, octylphenol ethylene oxide adduct, bisphenol A ethylene oxide adduct, dinonylphenol ethylene oxide adduct, styrenated phenol ethylene oxide adduct), a polyoxyalkylene alkylamino ether (e.g., laurylamine ethylene oxide adduct, stearylamine ethylene oxide adduct), and a polyoxyalkylene alkylalkanolamide (e.g., hydroxyethylaluric acid amide ethylene oxide adduct, hydroxypropyloleic acid amide ethylene oxide adduct, dihydroxyethylaluric acid amide ethylene oxide adduct).

The polyalcohol-type nonionic surfactant includes a polyalcohol fatty acid ester, a polyalcohol fatty acid ester alkylene oxide adduct, a polyalcohol alkyl ether, and a polyalcohol alkyl ether alkylene oxide adduct.

Specific examples of the polyalcohol fatty acid ester include pentaerythritol monolaurate, pentaerythritol monooleate, sorbitan monolaurate, sorbitan monostearate, sorbitan monolaurate, sorbitan dilaurate, sorbitan dioleate, and sucrose monostearate.

Specific examples of the polyalcohol fatty acid ester alkylene oxide adduct include ethylene glycol monooleate ethylene oxide adduct, ethylene glycol monostearate ethylene oxide adduct, trimethylolpropane monostearate ethylene oxide propylene oxide random adduct, sorbitan monolaurate ethylene oxide adduct, sorbitan monostearate ethylene oxide adduct, sorbitan distearate ethylene oxide adduct, and sorbitan dilaurate ethylene oxide propylene oxide random adduct.

Specific examples of the polyalcohol alkyl ether include pentaerythritol monobutyl ether, pentaerythritol monolauryl ether, sorbitan monomethyl ether, sorbitan monostearyl ether, methyl glycoside, and lauryl glycoside.

Specific examples of the polyalcohol alkyl ether alkylene oxide adduct include sorbitan monostearyl ether ethylene oxide adduct, methyl glycoside ethylene oxide propylene oxide random adduct, lauryl glycoside ethylene oxide adduct, and stearyl glycoside ethylene oxide propylene oxide random adduct.

Among these, the emulsifier for use in the present invention is preferably selected from a dispersant and a nonionic surfactant, and specific examples of more preferred emulsifiers are mentioned below. In the case where the hollow microballoon of the present invention includes a urethane(urea) resin, preferred is a polyvinyl alcohol or an anion-modified polyvinyl alcohol; and in the case where the hollow microballoon are formed of an amide resin, preferred is a sodium acrylate-acrylate copolymer. By selecting these, a stable emulsion can be formed.

In the case where the hollow microballoon includes a melamine resin or a urea resin, the emulsifier is preferably a styrene-maleic anhydride copolymer, and ethylene-maleic anhydride copolymer or an isobutylene-maleic anhydride copolymer. By neutralizing these with an alkaline compound such as sodium hydroxide, a high-density anionic polymer is produced, and this can promote polymerization of the component (B5) or the component (B6).

### <Organic solvent>

In the present invention, the organic solvent used for the component (a) or the component (c) is not specifically limited so far as it can dissolve the component (B1), the component (B7) or the oleophilic component (A), and examples thereof include hydrocarbons, halides and ketones.

Above all, preferred are those having a boiling point of 200°C or lower, for removing the organic solvent from the inside of microballoon to give hollow microballoon, and more preferred are those having a boiling point of 150°C or lower. Examples thereof are listed below.

### (Hydrocarbons)

Mentioned are aliphatic hydrocarbon having 6 to 11 carbon atoms, such as n-hexane, n-heptane and n-octane, an aromatic hydrocarbon such as benzene, toluene and xylene, and an alicyclic hydrocarbon such as cyclohexane, cyclopentane and methylcyclohexane.

### (Halides)

Mentioned are chloroform, dichloromethane, tetrachloroethane, and mono or dichlorobenzene.

### (Ketones)

Mentioned is methyl isobutyl ketone.

One alone or two or more kinds of these organic solvents can be used either singly or as a mixed solvent thereof.

In particular, the organic solvent for use in the present invention is more preferably n-hexane, n-heptane, n-octane, benzene, toluene, xylene, or the like.

### <Additive>

In the present invention, for the purpose of more stabilizing the emulsion, an additive may be added to the aqueous phase within a range not detracting from the advantageous effects of the present invention. Such an additive includes a water-soluble salt such as sodium carbonate, calcium carbonate, potassium carbonate, sodium phosphate, potassium phosphate, calcium phosphate, sodium chloride or potassium chloride. One alone or two or more kinds of these additives can be used either singly or as combined.

### <Catalyst>

### (Urethanation catalyst)

In the present invention, for the urethanation catalyst to be used in the case of synthesizing an urethane prepolymer of the component (B 12) or in the case where the hollow microballoon includes a urethane(urea)resin, any appropriate one can be used with no limitation. Specific examples are mentioned: triethylenediamine, hexamethylenetetramine, N,N-dimethyloctylamine, N,N,N',N'-tetramethyl-1,6-diaminohexane, 4,4'-trimethylenebis(1-methylpiperidine), 1,8-diazabicyclo-(5,4,0)-7-undecene, dimethyltin dichlcoride, dimethyltin bis(isooctylthio glycolate), dibutyltin dichloride, dibutyltin dilaurate, dibutyltin maleate, dibutyltin maleate polymer, dibutyltin diricinolate, dibutyltin bis(dodecyl mercaptide), dibutyltin bis(isooctylthio glycolate), dioctyltin dichloride, dioctyltin maleate, dioctyltin maleate polymer, dioctyltin bis(butyl maleate), dioctyltin dilaurate, dioctyltin diricinolate, dioctyltin dioleate, dioctyltin di(6-hydroxy)caproate, dioctyltin bis(isooctylthio glycolate), didodecyltin diricinolate, various metal salts such as copper oleate, copper acetylacetonate, iron acetylacetonate, iron naphthenate, iron lactate, iron citrate, iron gluconate, potassium octanoate, and 2-ethylhexyl titanate.

### (Amidation catalyst)

For the amidation catalyst to be used in the case where the hollow microballoon includes an amide resin, any appropriate one can be used with no limitation. Specific examples include boron and sodium dihydrogen phosphate.

### <Particle size of hollow microballoon>

The average particle size of the hollow microballoon of the present invention is not specifically limited, but is preferably 1 µm to 500 µm, more preferably 5 um to 200 µm, most preferably 10 to 100 um. Within the range, the hollow microballoon can express excellent polishing characteristics when used in CMP polishing pads.

For measurement of the average particle size of the hollow microballoon, a known method is employable. Specifically, an image analysis method is employable. Using an image analysis method, the particle size can be measured easily. The average particle size is an average particle size of primary particles. For measurement of the average particle size according to an image analysis method, for example, a scanning electron microscope (SEM) can be used.

### <Bulk density of hollow microballoon>

The bulk density of the hollow microballoon of the present invention is, though not specifically limited, preferably 0.01 to 0.5 g/cm³, more preferably 0.02 to 0.3 g/cm³. Within the range, optimum fine pores can be formed on the polishing surface of CMP polishing pads.

### <Ash content in hollow microballoon>

The ash content in the hollow microballoon of the present invention is, though not specifically limited, preferably 0.5 parts by mass or less per 100 parts by mass of the hollow microballoon, as measured according to the method described in the section of Examples to be given below, more preferably 0.3 parts by mass or less, even more preferably 0.1 parts by mass or less, and is most preferably unmeasurable. Within in the range, when the microballoon is used in CMP polishing pads, defects of wafers can be reduced.

### <Application to CMP polishing pad>

The CMP polishing pad of the present invention contains the above-mentioned microballoon. Specifically, the CMP polishing pad is preferably a resin containing the hollow microballoon. By containing the hollow microballoon in the resin, the CMP polishing pad can express excellent durability and excellent polishing characteristics.

As a method for producing such a CMP polishing pad, a known method is employable with no limitation. A resin containing the hollow microballoon of the present invention is cut and surface-polished to give a CMP polishing pad having fine pores on the polishing surface of the resin.

Though not specifically limited, the resin is preferably a urethane resin above all in the present invention.

In the case of the CMP polishing pad of a urethane resin containing the hollow microballoon of the present invention, the hollow microballoon-containing urethane resin to be used can be produced in any known method with no limitation. For example, in one method usable here, an isocyanate group-having compound, an active hydrogen group-having compound having an active hydrogen polymerizable with an isocyanate group, and the hollow microballoon of the present invention are uniformly mixed and dispersed and then cured.

Here, as the isocyanate group-having compound, for example, the above-mentioned component (B 1) can be used, though not specifically limited thereto. Among the component (B1), from the viewpoint of improving the polishing characteristics of CMP polishing pads, the urethane prepolymer (B 12) is preferred.

Also though not specifically limited, for example, the compound having an active hydrogen group with an active hydrogen polymerizable with an isocyanate group preferably contains at least one selected from the group consisting of the component (A), the component (B2), the component (B3) and the component (B4). Above all, from the viewpoint of improving the polishing characteristics of CMP polishing pads, the compound having an active hydrogen group with an active hydrogen polymerizable with an isocyanate group preferably contains at least the component (A), more preferably both the component (A) and the component (B3).

The curing method is not also specifically limited, and any known method is employable. Specifically, a dry method such as a one-pot method or a prepolymer method, and a wet method using a solvent can be used. Above all, a dry method is preferably employed.

In the case of the CMP polishing pad of a urethane resin, the amount of the hollow microballoon of the present invention to be blended in the urethane resin is preferably 0.1 to 20 parts by mass relative to 100 parts by mass of the total of the isocyanate group-having compound and the active hydrogen group-having compound having an active hydrogen polymerizable with an isocyanate group, more preferably 0.2 to 10 parts by mass, even more preferably 0.5 to 8 parts by mass. Within the range, excellent polishing characteristics can be expressed.

In the present invention, it is more favorable that, the cyclic polyfunctional monomer (A) in the present invention is contained as the active hydrogen group-having compound having an active hydrogen polymerizable with an isocyanate group, for more improving polishing characteristics.

In the present invention, the pattern of the CMP polishing pad is not specifically limited. For example, the surface may have a grooved structure. The grooved structure of the CMP polishing pad is preferably a form capable of retaining and renewing slurry, and specifically includes X (stripe) grooves, XY lattice grooves, concentric grooves, through-holes, non-through holes, polygonal prisms, columns, spiral grooves, eccentric grooves, radical grooves, and a combination of these grooves.

The production method for a grooved structure of the CMP polishing pad is not specifically limited. For example, there are mentioned a production method of casting the above-mentioned compounds into a mold having a predetermined grooved structure and curing them therein, and a production method of forming a grooved structure using a prepared resin, for example, a mechanically cutting method using a tool having bite of a predetermined size, a pressing method of pressing a resin with a pressing plate having a predetermined surface profile, a production method by photolithography, a production method using a printing method, and a production method with a laser light such as a carbon dioxide laser.

### Examples

Next, the present invention is described in detail with reference to Examples and Comparative Examples, but the present invention is not limited to these Examples. In the following Examples and Comparative Examples, the constituent components and evaluation methods are as mentioned below.

### (Molecular weight measurement: gel permeation chromatography (GPC measurement))

For GPC measurement, a liquid chromatograph apparatus (by Nihon Waters K.K.) was used. For the column, Shodex GPC KF-802 (exclusion limit molecular weight: 5,000), KF802.5 (exclusion limit molecular weight: 20,000), KF-803 (exclusion limit molecular weight: 70,000), KF-804 (exclusion limit molecular weight: 400,000), and KF-805 (exclusion limit molecular weight: 2,000,000), all by by Showa Denko K.K. were appropriately used depending on the molecular weight of the sample to be analyzed. As a developing liquid, dimethylformamide was used, and the sample was analyzed at a flow rate of 1 ml/min and a temperature of 40°C. Polystyrene was used as a standard sample, and the weight-average molecular weight was determined by comparative conversion. As a detector, a differential diffractometer was used.

### (Ash content)

The hollow microballoon were fired at a temperature of 600°C, and the ash content is a proportion of the mass of the firing residue and the mass of the hollow microballoon before firing.

### (Amount of residual tin)

The amount of residual tin in the cyclic polyfunctional monomer (A) was measured using an ICP emission spectrophotometer (i CAP 6500 DUO, by Thermo Fisher Scientific, Inc.) in which a mixed solution of methyl isobutyl ketone and isopropyl alcohol was used as the solvent.

### <Constituent components>

### (A) Cyclic polyfunctional monomer

### (Production of A-1)

Hydroxypropylated β-cyclodextrin (by CycloChem Co., Ltd.): 10 g and ε-caprolactone: 32.0 g were stirred at 130 °C with a flow of dry nitrogen to give a uniform solution, then dewatered under a reduced pressure of 20 kPa for 5 hours, and tin(II) 2-ethylhexanoate: 0.04 g was added and reacted for 16 hours to give a targeted product A-1. The physical properties of A-1 were as follows.
Weight-average molecular weight Mw (GPC): 4800
Dispersion degree (GPC): 1.05
Side chain modification degree: 0.43 (43%, as expressed in %)
Number of side chains introduced into cyclic molecule: 9
Kind of polymerizable functional group introduced into the terminal of side chain: hydroxy group
Molecular weight of side chain: about 560 as number-average molecular weight Viscosity at 60°C: 3,800 mPa·s
Amount of residual tin: 300 ppm

### (B) Polymerizable monomer other than the cyclic polyfunctional monomer (A)

### (B1) Component: Polyfunctional isocyanate compound having at least two isocyanate groups

### (B12) Component: Urethane prepolymer

Pre-1: Terminal isocyanate urethane prepolymer having an iso(thio)cyanate equivalent of 905

### (Production method for Pre-1)

In a flask equipped with a nitrogen-introducing tube, a thermometer and a stirrer, 50 g of 2,4-tolylene diisocyanate, 90 g of polyoxytetramethylene glycol (number-average molecular weight: 1,000) and 12 g of diethylene glycol were reacted in a nitrogen atmosphere at 80°C for 6 hours to give a terminal isocyanate urethane prepolymer (Pre-1) having an isocyanate equivalent of 905.

### (B3) Component: Polyfunctional amine compound

EDA: ethylenediamine
(B5) Component: melamine formaldehyde prepolymer compound
Nikaresin S-260 (by Nippon Carbide Industries Co., Inc.)
(Organic solvent)
Tol: Toluene
(Emulsifier)
PVA: Polyvinyl alcohol of a completely saponified type having an average polymerization degree of about 500

### <Example 1>

0.11 parts by mass of the component (A) A-1 and 1 part by mass of the component (B1) Pre-1 were dissolved in 15 parts by mass of toluene to prepare a component (a). Next, 10 parts by mass of PVA was dissolved in 150 parts by mass of water to prepare a component (b). Next, the prepared component (a) and component (b) were mixed, and stirred under the condition of 2,000 rpm × 10 minutes at 25°C using a high-speed shear disperser to give an O/W emulsion. At 25°C, an aqueous solution in which 0.04 parts by mass of ethylenediamine was dissolved in 30 parts by mass of water was dropwise added to the prepared O/W emulsion. After the dropwise addition, this was slowly stirred at 25°C for 60 minutes, and then stirred at 60°C for 4 hours to give a dispersion of microballoons of a urethane(urea) resin. The microballoons were taken out of the resultant microballoon dispersion by filtration, dried in vacuum at a temperature of 60°C for 24 hours, and then classified with a classifier to collect hollow microballoon 1. In filtrating the microballoon dispersion, ethylenediamine was not detected in the filtrate.

The component (A) was 9.6 parts by mass relative to 100 parts by mass of the total of the component (A) and the component (B) in the obtained hollow microballoon 1.

The average particle size of the hollow microballoon 1 was about 30 pm, the bulk density thereof was 0.1 g/cm³, and no ash was detected.

### <Comparative Example 1>

Hollow microballoon 2 were produced according to the same method as in Example 1, except that the component (A) was not used and ethylenediamine was changed to 0.05 parts by mass.

The proportion of the component (A) was 0 part by mass relative to 100 parts by mass of the total of the component (A) and the component (B) in the obtained hollow microballoon 2.

The average particle size of the hollow microballoon 2 was about 25 pm, the bulk density thereof was 0.1 g/cm³, and no ash was detected.

### <Example 2>

### (Production method for CMP polishing pad using hollow microballoon)

12 parts by mass of A-1 produced in the above and 5.5 parts by mass of 4,4'-methylenebis(o-chloroaniline) (MOCA) were mixed at 120°C to give a uniform solution, and then fully degassed to prepare a liquid A. Separately, 3.3 parts by mass of the hollow microballoon 1 produced in Example 1 were added to 82.5 parts by mass of Pre-1 produced in the above and heated up to 70°C, and stirred with a rotation/revolution stirrer to give a uniform solution. The liquid A controlled at 100°C was added thereto, and stirred with a rotation/revolution stirrer to give a uniform composition. The composition was cast into a mold, and cured at 100°C for 15 hours to produce a urethane resin containing the hollow microballoon.

The resultant urethane resin was sliced to give CMP polishing pad of urethane resin each having a thickness of 1 mm described below.

The density of the CMP polishing pad of urethane resin produced in the above was 0.80 g/cm³, the polishing rate thereof was 5.1 pm/hr, the surface roughness after polishing of wafers that are substances to be polished was 0.14 nm, and the Tabor wear loss in the Tabor wear test carried out for wear resistance evaluation of the CMP polishing pads was 14 mg. The evaluation methods are mentioned below.
(1) Polishing rate: The polishing conditions are shown below. Ten wafer samples were tested.
   Under the following conditions, the samples were polished, and the polishing rate was measured. The polishing rate is an average value of the data of the ten wafer samples.
   CMP polishing pad: Pad having a size of 500 mmϕ and a thickness of 1 mm, with concentric grooves formed on the surface.
   Substance to be polished: 2-inch sapphire wafer
   Slurry: FUJIMI Compol 80, undiluted liquid
   Pressure: 4 psi
   Rotation number: 45 rpm
   Time: 1 hr
(2) Surface roughness (Ra): The surface of each 10 wafer samples polished under the conditions in the above (1) was observed with a nanosearch microscope SFT-4500 (by Shimadzu Corporation) to measure the surface roughness (Ra) thereof. The surface roughness is an average value of the data of the ten wafer samples.
(3) Wear resistance: Using an apparatus of 5130 Model by Tabor Electronics Ltd., a wear loss was measured. The load was 1 kg, the rotation speed was 60 rpm, the rotation number was 1000 rotations, and the wear ring was H-18. In the Tabor wear test, the same portion of the same sample was measured two times in each sample, and the wear resistance was evaluated by the average value of the found data.

### <Example 3, Comparative Examples 2 to 3>

CMP polishing urethane resin pads were produced and evaluated in the same manner as in Example 2 except that the composition shown in Table 1 was used. The results are shown in Table 1.

**Table 1**

| | Hollow Microballoon (part by mass) | Urethane Resin Composition (part by mass) | Density (g/cm³) | Polishing Rate pm/hr | Wafer Surface Roughness Ra nm | Wear Resistance (mg) |
|---|---|---|---|---|---|---|
| Example 2 | Microballoon 1 (3.3) | A-1(12)/Pre-1(82.5)/MOCA(5.5) | 0.80 | 5.1 | 0.14 | 14 |
| Example 3 | Microballoon 1 (3.3) | Pre-1(88)/MOCA(12) | 0.80 | 3.0 | 0.20 | 55 |
| Comparative Example 2 | Microballoon 2 (3.3) | A-1(12)/Pre-1(82.5)/MOCA(5.5) | 0.85 | 4.1 | 0.21 | 22 |
| Comparative Example 3 | Microballoon 2 (3.3) | Pre-1(88)/MOCA(12) | 0.80 | 2.0 | 0.25 | 70 |

As known from the results in Table 1, the CMP polishing pads using the hollow microballoon containing the cyclic polyfunctional monomer (A) of the present invention have an improved polishing characteristics having an excellent polishing rate capable of more smoothly polishing wafers as the substances to be polished, and the like. In addition, the handleability in producing the hollow microballoon of the present invention is good.

As described above, it is preferable that the resin composition of the CMP polishing pad base also contains the cyclic polyfunctional monomer (A), but as obvious from comparison between Example 3 and Comparative Example 3, even in the case where the resin composition of the CMP polishing pad base does not contain the component (A), the polishing characteristics can be improved by using the hollow microballoon of the present invention.

## Claims

1. A hollow microballoon comprising a resin produced by polymerizing a polymerizing composition that contains (A) a cyclic molecule having at least three side chains with a polymerizable functional group introduced into the terminal thereof and (B) a polymerizable monomer other than the (A) cyclic molecule having at least three side chains with a polymerizable functional group introduced into the terminal thereof.

2. The hollow microballoon according to claim 1, wherein the content of the (A) cyclic molecule having at least three side chains with a polymerizable functional group introduced into the terminal thereof contained in the polymerizable composition is 1 to 50 parts by mass relative to 100 parts by mass of the total of the content of the (A) cyclic molecule having at least three side chains with a polymerizable functional group introduced into the terminal thereof and the (B) polymerizable monomer other than the (A) cyclic molecule having at least three side chains with a polymerizable functional group introduced into the terminal thereof.

3. The hollow microballoon according to claim 1 or claim 2, wherein the resin comprises a urethane(urea) resin, a melamine resin, a urea resin or an amide resin.

4. The hollow microballoon according to any one of claims 1 to 3, wherein the polymerizable functional group of the (A) cyclic molecule having at least three side chains with a polymerizable functional group introduced into the terminal thereof comprises a hydroxy group or an amino group.

5. The hollow microballoon according to any one of claims 1 to 4, wherein the cyclic molecule comprises a cyclodextrin.

6. The hollow microballoon according to any one of claims 1 to 5, wherein the viscosity at 60°C of the (A) cyclic molecule having at least three side chains with a polymerizable functional group introduced into the terminal thereof is 500 mPa ·s to 50,000 mPa -s

7. A polishing pad for CMP comprising the hollow microballoon of any one of claims 1 to 6.
